# FASCICULE DE BREVET EUROPEEN

(11) **EP 3 813 255 B1**
(45) Date de publication et mention de la délivrance du brevet: **03.12.2025**
(21) Numéro de dépôt: 20203209.0
(22) Date de dépôt: 22.10.2020
(51) Int. Cl.: H03F 1/38, H03F 3/195, H03F 3/72, H03F 3/68, H03B 5/00, H04W 24/06, H04B 17/19, H04B 17/29, H03B 5/12, H04B 17/13

(54) **CIRCUIT INTEGRE RADIOFREQUENCE ET PROCEDE DE TEST CORRESPONDANT**
INTEGRIERTER FUNKFREQUENZ-SCHALTKREIS UND ENTSPRECHENDES TESTVERFAHREN
RADIOFREQUENCY INTEGRATED CIRCUIT AND CORRESPONDING TEST METHOD

(30) Priorité: 22.10.2019 FR 1911797
(43) Date de publication de la demande: 28.04.2021
(73) Titulaire: Commissariat à l'Energie Atomique et aux Energies Alternatives, 75015 Paris (FR)
(72) Inventeur: MARTINEAU, Baudouin, 38054 GRENOBLE Cedex 09 (FR); DEHOS, Cédric, 38054 GRENOBLE Cedex 09 (FR)
(74) Mandataire: Atout PI Laplace

(56) Documents cités:
- EP-A1- 1 201 051
- EP-A2- 0 920 146
- US-A1- 2009 191 838
- US-A1- 2012 257 656
- ABHILASH GOYAL ET AL: "A self-testable SiGe LNA and Built-in-Self-Test methodology for multiple performance specifications of RF amplifiers", QUALITY ELECTRONIC DESIGN (ISQED), 2012 13TH INTERNATIONAL SYMPOSIUM ON, IEEE, 19 March 2012 (2012-03-19), pages 7 - 12, XP032169334, ISBN: 978-1-4673-1034-5, DOI: 10.1109/ISQED.2012.6187467
- MAKHSUCI SAEEDEH ET AL: "Oscillation-based Test for Measuring 1dB Gain Compression Point of Power Amplifiers", ELECTRICAL ENGINEERING (ICEE), IRANIAN CONFERENCE ON, IEEE, 8 May 2018 (2018-05-08), pages 190 - 195, XP033408630, ISBN: 978-1-5386-4914-5, [retrieved on 20180925], DOI: 10.1109/ICEE.2018.8472454

## Description

L'invention concerne le test et la caractérisation in situ de circuits intégrés d'émission et/ou réception radiofréquence et plus particulièrement des circuits intégrés qui réalisent la partie de circuiterie frontale ou "*Front-End*" qui comprend a minima l'amplificateur à faible bruit qui est le premier étage d'e ntrée de voie de réception et/ou l'amplificateur de puissance qui est le dernier étage de sortie de la voie d'émission et qui sont les étages raccordés aux antennes. L'invention s'applique notamment mais non limitativement, au test des modules frontaux réalisés pour le domaine des communications en bande millimétrique (typiquement de 6 à 100 GHz), pour des applications grand public basées sur l'interopérabilité d'objets communiquants (automobile, habitat, agroalimentaire, médecine).

L'invention adresse plus particulièrement les architectures de terminaux de communication dans lesquelles la partie électronique analogique radiofréquence qui est raccordée aux antennes est réalisée par des circuits intégrés, appelés modules frontaux, un par antenne, qui sont assemblés à un ou d'autres circuits intégrés pour former la chaine complète des voies d'émission/réception entre un processeur de traitement de signal et des antennes. Cette conception permet d'optimiser le coût et la taille du terminal au plus près des besoins d'une application, notamment en permettant l'utilisation de technologies différentes selon les circuits intégrés. Par exemple, selon la portée de transmission en espace libre demandée, on a besoin de plus ou moins de puissance, ce qui conditionne le nombre de modules frontaux et d'antennes à utiliser, en fonction de la technologie de semi-conducteur utilisée. Typiquement, avec des technologies AsGa ou GaN, performantes pour l'amplification des signaux radiofréquence, on utilisera significativement moins d'antennes qu'en technologie CMOS, mais pour un coût significativement plus élevé.

Pour réduire le coût et la taille des modules frontaux en technologie AsGa, on propose par exemple de n'intégrer principalement dans ces modules que la partie électronique de puissance pour laquelle elle est spécialement performante, et les autres fonctions électroniques radiofréquence sont réalisées dans une technologie moins coûteuse en termes de densité d'intégration et de fabrication (CMOS, FinFET par exemple). Lorsque le coût du module n'est pas un enjeu majeur, ou lorsque le module est réalisé dans une technologie moins coûteuse, ces modules frontaux peuvent intégrer d'autres fonctionnalités électronique radiofréquence, telles que des fonctions de filtrage, ou de transposition de fréquence sont déportées dans le circuit électronique principal qui assure déjà toute l'électronique en bande de base, voire dans d'autres circuits intégrés intermédiaires.

Or si on prend en exemple des portées de transmission (en espace libre) supérieures à quelques dizaines de centimètres, il est nécessaire d'utiliser un grand nombre d'antennes, de l'ordre de plusieurs centaines, et jusqu'à un millier, selon la technologie de semi-conducteur utilisée, pour fournir la puissance nécessaire. A des fréquences élevées (supérieures à 10 GHz environ), il est également nécessaire d'avoir un gain d'antenne élevé ; un moyen d'y parvenir est d'utiliser un réseau d'antennes comprenant un grand nombre d'antennes élémentaires.

Pour des applications grand public, la testabilité de ces modules frontaux, en volume est ainsi un enjeu majeur. La part du coût du test dans le coût total d'un terminal doit être réduite au maximum. Cette question du test se pose au fabricant du circuit, mais aussi à l'assembleur final (qui n'est pas nécessairement le fabricant des modules frontaux choisis).

Dans le domaine général de la testabilité en volume de circuits intégrés d'émission/réception radiofréquence, où il s'agit de vérifier que les performances en émission et réception sont conformes aux spécifications du produit, la tendance générale est de ne pas faire des tests en radiofréquence, car c'est bien trop contraignant et coûteux en termes d'équipements de test (équipements de test spécifiques et/ou antennes de référence), d'impact surfacique sur les circuits intégrés à tester (blindages pour éviter des effets de couplage parasites avec les sondes ou pointes de test) et de temps de test.

On cherche plutôt à utiliser des solutions dites de test indirect, basées sur des signaux numériques faciles à générer et à lire, qui consistent notamment à intégrer des ressources de test dans les circuits intégrés, ces ressources de test étant conçues pour se combiner aux ressources fonctionnelles propres du circuit intégré sous test, pour permettre de tester les chaines analogiques. On parle d'auto-test intégré, désigné par l'acronyme anglais BIST (pour "*Built In Self Test*")*.* Par exemple le document "Indirect Analog / RF IC testing : Confidence Robusteness improvments", thèse de Haithem Ayari soutenue le 12 décembre 2013 à l'Université de Montpellier II (HAL Id: tel-00998677, "https://tel.archives.ouvertes.fr/tel-00998677") propose un commutateur intégré de rebouclage de la voie d'émission sur la voie de réception, activable en test, permettant à partir d'un stimuli numérique de la voie d'émission, d'émuler la chaine complète de réception avec le signal radiofréquence produit en sortie par la voie d'émission, et ce qui est analysé, c'est le signal numérique obtenu en sortie de la voie de réception. EP0920146A2, EP1201051B1 et US2012257656A1 divulguent également des circuits de rebouclage des voies d'émission et/ou de réception afin de les tester.

Ces solutions ne répondent pas au problème de test des modules frontaux dont les signaux d'entrée et de sortie des voies d'émission et de réception sont des signaux radiofréquence haute-fréquence. Pour ces modules, le problème de la génération de stimuli de test radiofréquence, de bonne qualité, reste entier car les testeurs sont dans la majorité des cas non capables de générer des signaux haute-fréquence, et même si c'est le cas l'utilisation de cette fonctionnalité de test avec génération de signaux RF est très couteuse. En outre la solution BIST décrite ci-dessus, de rebouclage de la sortie radiofréquence de la voie d'émission sur l'entrée radiofréquence de la voie de réception ne permet pas de qualifier séparément la voie de réception (gain, facteur de bruit) et la voie d'émission (gain), sauf à prévoir des points de test dans le module, pour analyser les signaux. On retrouve le problème de l'utilisation de sondes ou de pointes de test, pour des signaux radiofréquence.

Enfin, il y aurait un intérêt pour l'assembleur, à pouvoir vérifier pour chaque module frontal, avant son assemblage sur la carte de circuit imprimé du terminal, que la connexion antennaire est conforme. Cette vérification d'une "bonne" connexion entre la puce de module frontal et son antenne ou ses antennes est très importante, car les amplificateurs d'entrée et de sortie ne seront performants que s'il y a une bonne adaptation de leur impédance d'entrée ou de sortie avec l'antenne. Or si cette l'impédance amenée par la connexion à l'antenne est trop faible (défaut de connexion du type court-circuit à la masse), on n'aura pas ou trop peu de tension en sortie ; Si cette impédance est trop élevée, on aura beaucoup trop de tension, avec un risque de destruction des amplificateurs du module, plus spécialement, de claquage des transistors de l'amplificateur de puissance. Cette vérification ne peut se faire par un test de continuité électrique. Il faut vérifier un niveau de puissance radiofréquence en sortie de l'amplificateur de sortie (amplificateur de puissance) au plus près de l'antenne. Dans le cas d'une voie de réception connectée à son antenne propre (mode duplex intégral), c'est plus compliqué, sauf à émettre une onde juste devant l'antenne pour mesurer le signal reçu derrière l'antenne, entre le plot de connexion à l'antenne et l'entrée de l'amplificateur à faible bruit en entrée de la voie de réception. Ce serait bien trop coûteux et inadapté à du test en volume.

On a donc une problématique de test en volumes de modules frontaux, en se passant de la génération par le testeur d'un signal radiofréquence, et en le réalisant à moindre coût, sans utiliser ni antennes de référence, ni équipements spécialisés coûteux ni sondes ou pointes de test.

On a donc besoin de trouver une solution de test universelle et peu coûteuse, permettant de réaliser une vraie économie d'échelle pour un test in situ de circuits intégrés radiofréquence en volume, qui permette de vérifier l'état de la connexion antennaire, et/ou qui permette avantageusement d'évaluer les qualités de la voie d'émission et/ou de la voie de réception le plus indépendamment possible des ressources fonctionnelles du circuit intégré sous test.

### RESUME DE L'INVENTION

Une idée à la base de l'invention consiste à reconfigurer un amplificateur présent dans un module frontal (amplificateur à bas bruit et/ou amplificateur de puissance) en oscillateur, notamment en activant, de manière commandée, une boucle de réaction positive. L'oscillateur ainsi formé génère un signal RF dans la bande de fonctionnement du module frontal, ce qui permet de tester un ou plusieurs composants de ce dernier (autres que l'amplificateur lui-même) et/ou sa connexion d'antenne.

Comme cela sera expliqué en détail plus loin, l'utilisation d'un amplificateur reconfigurable entraine une complexification minime de l'électronique du module frontal, bien moindre que celle qui serait entrainée par l'ajout d'un oscillateur dédié. Certes, dans le cas où les puces de module frontal à tester intègrent un étage de transposition de fréquence (mélangeur), on dispose parfois d'un oscillateur local opérant dans la bande radiofréquence utile. Dans ce cas, il serait possible d'envisager une solution analogique BIST pour permettre, en mode de test, une utilisation spécifique de cet oscillateur local, pour fournir un signal radiofréquence de test. Néanmoins, une telle utilisation nécessiterait d'intégrer des chemins de transmission de ce signal RF vers des nœuds d'entrée des voies d'émission et de réception et à proximité du ou des plots de connexion d'antenne, ce qui n'est pas toujours possible ni souhaitable. Et surtout, cela ne résoudrait absolument pas le cas de modules frontaux qui ne comporteraient pas d'oscillateurs locaux. L'invention ne présente pas de tels inconvénients.

Un objet de l'invention, permettant d'atteindre ce but, est un circuit intégré d'émission et/ou réception radiofréquence tel que définit dans la revendication 1.

L'utilisation d'amplificateurs reconfigurables en oscillateurs pour realizer des BIST est connue en soi, voir par exemple:
- M. Saeedeh et al « Oscillation-based Test for Measuring 1dB Gain Compression Point of Power Amplifiers », IEEE Iranian Conference on Electrical Engineering, 8 mai 2018, pages 190 - 195 ;
- A. Gioyal et al, « A self-testable SiGe LNA and built-in-self-test methodology for multiple performance specifications of RF amplifiers », IEEE Thirteenth International Symposium on Quality Electronic Design, 19 mars 2012, pages 7-12;
- US2009/0191838 A1; et
- B. Maxwell et al. « Built-in Oscillation-Based Testing of RF Amplifier Gain using Differential Power Detection», IEEE Radio and Antenna Days of the Indian Ocean (RADIO) Radio Society, 23 septembre 2019, pages 1-2.

Dans ces publications, cependant, le but est de tester ou caractériser l'oscillateur lui-même qui, pour ce faire, est déconnecté du reste du circuit. Dans le cas de l'invention, au contraire, le signal généré par l'amplificateur converti en oscillateur est utilisé pour tester ou caractériser d'autres composants du circuit intégré d'émission-réception radiofréquence. Par exemple, lorsque l'amplificateur converti en oscillateur est un amplificateur à bas bruit d'une voie de réception du circuit intégré, le signal oscillatoire ainsi généré peut être utilisé pour tester ou caractériser la connexion d'antenne à l'entrée de l'amplificateur et/ou l'ensemble de la chaîne de réception voire - à condition de prévoir le rebouclage d'une sortie de la voie de réception sur une entrée correspondante de la voie d'émission - l'intégralité de la voie d'émission. De même, lorsque l'amplificateur converti en oscillateur est un amplificateur de puissance d'une voie d'émission du circuit intégré, le signal oscillatoire ainsi généré peut être utilisé pour tester ou caractériser la connexion d'antenne à la sortie de l'amplificateur, un filtre ou un stade ultérieur d'amplification, voire - à condition de prévoir le rebouclage d'une sortie de la voie d'émission sur une entrée correspondante de la voie de réception - l'intégralité de la voie de réception.

Un autre objet de l'invention est un procédé d'auto-test tel que définit dans la revendication 12.

Différents modes de réalisation de ce circuit et de ce procédé constituent l'objet des revendications dépendantes.

### BREVE DESCRIPTION DES DESSINS

L'invention sera mieux comprise et d'autres avantages apparaîtront à la lecture de la description détaillée de modes de réalisation donnés à titre d'exemple, et illustrée par le dessin joint dans lequel :
[Fig.1] la figure 1 est un schéma-bloc d'un exemple de terminal de communication en bande millimétrique, comportant des modules frontaux radiofréquence raccordés à des antennes respectives, assemblés à un circuit intégré principal assurant le traitement analogique et/ou numérique en bande de base ou basse fréquence ;
[Fig.2] la figure 2 est un schéma-bloc d'un module frontal pour un mode communication semi-duplex intégrant des ressources de test selon l'invention, selon un premier mode d'implémentation de l'invention ;
[Fig.3] la figure 3 illustre un exemple de réalisation de moyens d'analyse d'une caractéristique BF (tension crête) de signal sinusoïdal utilisable dans l'invention ;
[Fig.4] la figure 4 est un organigramme d'un procédé d'auto-test correspondant ;
[Fig.5] la figure 5 représente la variation de la forme d'onde d'un signal sinusoïdal Sin_{RF} généré par un amplificateur reconfiguré en oscillateur électronique selon un principe de l'invention, en fonction de l'impédance de charge de l'amplificateur ;
[Fig.6] la figure 6 illustre un principe de détection d'état de connexion antennaire d'un module frontal selon l'invention basé sur cette variation de forme d'onde signal sinusoïdal avec l'impédance de charge ;
[Fig.7] la figure 7 illustre est un schéma-bloc d'un module frontal pour un mode de communication en duplex intégral, intégrant des ressources de test selon l'invention correspondant à un deuxième mode d'implémentation de l'invention ;
[Fig.8] la figure 8 illustre une topologie à paire différentielle d'un amplificateur à faible bruit LNA et d'un amplificateur de puissance PA utilisable dans le module frontal de la figure 6 ;
[Fig.9] la figure 9 est un schéma électrique simplifié d'une structure d'entrée d'un amplificateur à faible bruit à paire différentielle, comprenant des capacités de neutrodynage ;
[Fig.10] la figure 10 est un schéma électrique de cette structure transformée selon l'invention, permettant un fonctionnement en amplificateur en mode opérationnel ou en oscillateur en mode de test ;
[Fig.11] la figure 11 est un schéma électrique simplifié d'un étage d'amplificateur à faible bruit dans une topologie non différentielle de type cascode, à dégénerescence d'inductance ;
[Fig.12] la figure 12 montre une transformation astucieuse de cette structure, pour réaliser un amplificateur reconfigurable en oscillateur électronique en mode de test selon l'invention;
[Fig.13] la figure 13 est un schéma électrique simplifié d'un étage d'amplificateur à de puissance dans une topologie non différentielle de type cascode ;
[Fig.14] la figure 14 illustre une transformation de cette structure en amplificateur de reconfigurable en oscillateur électronique, selon l'invention ; et
[Fig. 15] la figure 15 illustre un système antennaire comprenant une pluralité de modules frontaux réalisés dans des technologies différentes.

On rappelle que les figures sont de simples schémas illustrant l'invention. Par souci de clarté et de simplification, les mêmes notations ou références ont été utilisées tout au long de la description et dans les figures pour désigner les mêmes éléments ou des éléments similaires.

L'emploi des expressions "reconfigurable en oscillateur" ou "reconfiguré en oscillateur" s'appliquant aux amplificateurs d'entrée (LNA) et de sortie (PA) des circuits radiofréquence raccords aux antennes, doit être compris comme plaçant ces amplificateurs dans un mode de fonctionnement dans lesquels, au lieu d'amplifier un signal présent à leur entrée, ces amplificateur oscillent, c'est-à-dire génèrent spontanément un signal alternatif, par exemple (mais pas nécessairement) sinusoïdal. Typiquement, la reconfiguration en oscillateur est obtenue en activant, au moyen d'un signal de commande (par exemple de type logique) une boucle de réaction positive.

Le terme "connecté" indique une connexion électrique directe ; et le terme "couplé", ou "raccordé", indique une connexion qui peut être directe ou indirecte, à travers au moins un composant intermédiaire.

Le terme « composant » désigne tout bloc fonctionnel, passif ou actif, du circuit intégré radiofréquence tel un amplificateur, un filtre, un mélangeur, etc. voire simplement un plot de connexion à un élément exterieur tel qu'une antenne ou un autre circuit intégré.

Radiofréquence (RF) désigne un signal présentant une fréquence centrale d'au moins 1 MHz. Généralement, un signal radiofréquence comprend au moins une porteuse modulée par une enveloppe, en général complexe, dont le spectre présente une fréquence maximale bien inférieure à celle de la porteuse. Dans la suite, par « basse fréquence » (BF) on entend une fréquence inférieure d'au moins un facteur 10 à la fréquence de l'enveloppe ; il s'agit donc d'une notion relative. Une « caractéristique basse fréquence » d'un signal RF est donc une propriété de son enveloppe.

Dans les figures, la symbologie des transistors correspond à celle de transistors à effet de champ dans une technologie CMOS à canal N. L'homme du métier sait faire les transpositions (alimentations) à d'autres type de transistors à effet de champ (à canal P, ou dans des technologies de semi-conducteur autres comme des technologies CMOS avancées (FinFET) ou des technologies GaN, AsGa, SiGe).

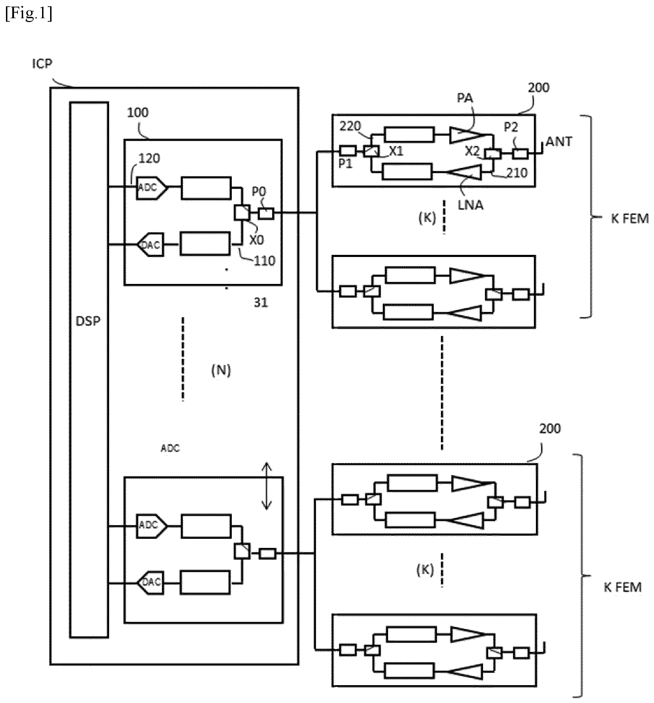

Un terminal de communication plus particulièrement destiné à la bande millimétrique est schématiquement illustré en exemple sur la figure 1. Il s'agit dans l'exemple d'un terminal du type à faisceau directif à N voies, à commande de déphasage de porteuse, raccordé à N groupes de K antennes, un groupe par voie. Selon la technologie d'antenne utilisée pour l'application, le terme "antenne" peut désigner un élément d'antenne ou plusieurs éléments d'antenne en réseau.

Le terminal comprend dans l'exemple un circuit intégré principal ICP et NxK modules frontaux 200 chacun raccordé à une antenne respective ANT. Le circuit intégré comprend un processeur de traitement de signal DSP pilotant N étages d'émission/réception 100, qui pilotent chacun K modules frontaux 200. Cette architecture à K modules/antennes par voie permet de répondre au besoin en puissance de l'application.

Chaque module frontal 200 comprend entre un premier plot P1 de connexion E/S au circuit intégré principal ICP et un plot P2 de connexion à une antenne respective ANT :
- une voie d'émission radiofréquence 220 comprenant au moins un amplificateur de puissance PA (encore appelé amplificateur de sortie dans la suite) dont la sortie est raccordée au plot d'antenne P2 via un commutateur de voie X2 ;
- une voie de réception radiofréquence 210 comprenant au moins un amplificateur à faible bruit LNA (encore appelé amplificateur d'entrée dans la suite) dont l'entrée est raccordée au plot d'antenne P2 via le commutateur d'antenne X2.

Les deux voies d'émission et réception radiofréquence sont connectées respectivement en entrée et sortie au plot P1 par un autre commutateur de voie X1.

D'autres fonctions analogiques radiofréquence peuvent être intégrées dans le module frontal, en fonction de la technologie de semi-conducteur et/ou de la technique de communication. On peut notamment avoir des amplificateurs à gain réglable, des déphaseurs ou des filtres, des mélangeurs associés à un oscillateur local. La liste n'est pas limitative. Mais ces fonctions peuvent aussi être déportées dans le circuit intégré principal ICP comme illustrées sur la figure 1, ou dans des circuits intégrés intermédiaires. Dans ce cas le module frontal comprend essentiellement l'amplificateur d'entrée de la voie de réception radiofréquence (amplificateur à faible bruit LNA) et l'amplificateur de sortie de la voie d'émission radiofréquence, raccordés d'un côté à un plot de connexion d'antenne, qui dans l'exemple est commun, et de l'autre, à un plot d'E/S de signal, également commun, pour la connexion au circuit intégré principal. On peut alors concevoir le module de façon optimale en termes de surface et de performances d'amplification radiofréquence (gain, bruit (LNA), linéarité (PA) en fonction de la technologie semi-conducteur employée).

Dans l'exemple, le circuit intégré principal ICP comprend un processeur de traitement de signal DSP qui assure les traitements en bande de base pour les N voies, incluant par exemple les fonctions de modulation/démodulation quand elles sont en numérique (par exemple modulation en quadrature de phase), et qui pilote en parallèle N voies d'émission/réception 100 qui comprennent les étages de conversion analogique ↔numérique DAC et ADC, de transposition de fréquence (mélangeurs TF et oscillateurs locaux OL), et d'amplification en entrée et sortie. Pour chaque bloc, un commutateur de voie X0 permet de raccorder la sortie de voie d'émission 110 ou l'entrée de voie de réception 120 à un plot P0 d'interface E/S correspondant. Ce plot P3 est raccordé par un réseau de conducteurs d'interconnexions du terminal, aux plots P1 des M circuits radiofréquence associés.

La présente invention ne concerne pas une technique de communication particulière ni une architecture de terminal spécifique, mais bien des facultés d'autotest in situ de tels modules frontaux 200 pour un tel terminal de communication radiofréquence. L'homme du métier saura appliquer l'invention qui va maintenant être détaillée aux différentes techniques de communication utilisées.

Dans l'invention, au moins un amplificateur parmi l'amplificateur d'entrée LNA et/ou l'amplificateur de sortie PA du module frontal est un amplificateur reconfigurable en oscillateur électronique sur commande pour produire un signal sinusoïdal radiofréquence. Si le module frontal a été conçu pour l'émission/réception dans la bande de fréquence dite 60 GHz, ce qui correspond en pratique à des fréquences de porteuse situées entre 57 et 66 GHz, la fréquence du signal sinusoïdal généré par auto-oscillation de l'amplificateur sera dans cette bande de fréquence, par exemple autour de 62 GHz.

On obtient de cette façon un signal sinusoïdal à haute fréquence sur la ligne de transmission de signal entre l'amplificateur reconfiguré en oscillateur et la borne de connexion d'antenne P2 du module. Selon la typologie d'amplificateur et plus particulièrement de sa structure lorsqu'il est configuré en oscillateur, le signal sinusoïdal fourni par l'oscillateur pourra être présent sur l'entrée et/ou la sortie de l'amplificateur. En outre, le signal sinusoïdal pourra être présent sur l'entrée et la sortie de l'amplificateur reconfiguré en oscillateur, avec des niveaux de puissance très différents.

De manière plus précise, s'agissant de l'amplificateur de réception, à faible bruit, le premier étage de cet amplificateur, qui est celui dont l'entrée est couplée au plot de connexion d'antenne (directement ou indirectement à travers un transformateur dans cas d'un amplificateur différentiel ; et/ou d'un commutateur de voie en cas de module à semi duplex et/ou d'un filtre d'antenne), est de préférence reconfigurable en oscillateur, notamment si on souhaite que le signal sinusoïdal soit émis du côté de l'antenne. Il n'est pas indispensable que les autres étages de l'amplificateur (qui en comporte généralement au moins deux pour les applications qui nous occupent) soit reconfigurables (même si cela peut être envisagé). La reconfiguration du premier étage de l'amplificateur en oscillateur devra permettre une propagation du signal sinusoïdal vers le reste de la chaîne de réception si on souhaite propager un signal RF dans cette direction pour réaliser un test.

Le signal sinusoïdal ainsi généré est utilisé dans l'invention comme signal de test pour la vérification antennaire ou bien comme signal de calibration radiofréquence de la voie d'émission, , ou bien comme signal de calibration radiofréquence de la voie de réception, comme on va l'expliquer.

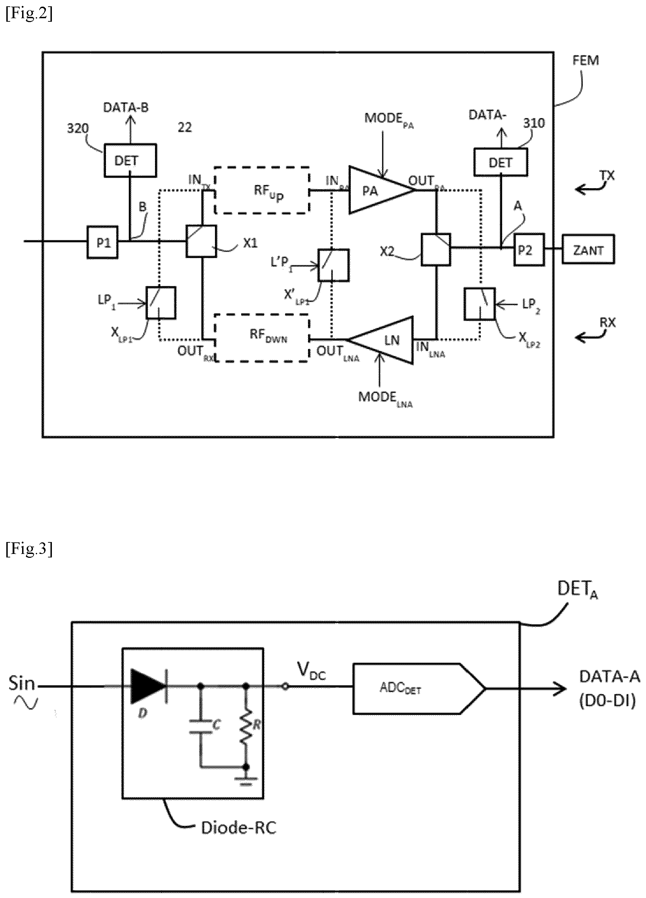

Il convient de noter que les figures 2, 7 et 8 sont essentiellement des schémas de principe qui ne rendent pas compte des différents choix électroniques d'implémentation (par exemple signal différentiel ou non différentiel) ni des choix techniques de commutation (par exemple modulation numérique à quadrature de phase) pour un module donné. Dans la suite de la description, on précisera le cas échéant comment les différents aspects techniques sont pris en compte pour les implémentations pratiques de l'invention.

La figure 2 est un schéma bloc d'un module frontal FEM illustrant un mode de réalisation de l'invention. Dans l'exemple le module FEM est adapté à un mode de communication semi-duplex. Il comprend une seule borne P2 de connexion à une antenne ANT associé à un commutateur de voie X2, et une seule borne P1 d'entrée/sortie de signal, qui réalise l'interface avec l'électronique de traitement en bande de base (CIP, figure 1).

La voie de réception radiofréquence RX comprend un amplificateur faible bruit LNA dont l'entrée de signal IN_{LNA} est raccordée au plot d'antenne P2 via le commutateur X2 en mode réception RX, et peut ou non comprendre une circuiterie électronique aval RF_{DWN}. Quand elle est présente, cette circuiterie RF_{DWN} a une topologie qui dépend du ou des modes de communication mis en œuvre. A titre d'exemple non limitatif, cette circuiterie RF_{DWN} peut comprendre : un mélangeur de fréquence associé à un oscillateur local pour réaliser une transposition en bande de base du signal radiofréquence OUT_{LNA} qui est délivré en sortie par l'amplificateur LNA, suivi d'un filtre en bande de base et d'un circuit de contrôle automatique de gain. Le signal OUT_{RX} de sortie de voie de réception est appliqué via le commutateur X1 sur le plot P1 d'E/S du module.

La voie d'émission radiofréquence TX comprend un amplificateur de puissance PA dont la sortie est raccordée au plot d'antenne P2 via le commutateur X2 en mode émission TX, et qui peut ou non comprendre une circuiterie électronique amont RF_{UP}, non détaillée, qui le cas échéant aurait une topologie correspondant aux besoins de l'application, duale de celle la circuiterie RF_{DWN} de la voie de réception. Dans l'exemple, elle pourrait ainsi comprendre : un filtre en bande de base suivi d'un mélangeur de fréquence avec un oscillateur local, fournissant le signal radiofréquence IN_{PA} en entrée de l'amplificateur de puissance.

La configuration exacte de ces circuiteries RFD_{WN} et RF_{UP} n'est pas essentielle à l'invention, et d'autres configurations sont possibles. Par exemple, dans une topologie de modulation/démodulation numérique I, Q, à quadrature de phase, les circuits RF_{DWN} et RF_{UP} comporteraient chacun deux branches identiques, une par quadrature, avec un oscillateur local fournissant deux signaux d'oscillateur local en quadrature, un pour chaque branche et seraient couplés respectivement en sortie et en entrée, à deux plots d'E/S de signal, correspondants aux deux signaux I et Q (non illustré).

L'amplificateur à faible bruit LNA et/ou l'amplificateur de puissance PA ont chacun deux modes de fonctionnement possibles : un mode opérationnel, dans lequel l'amplificateur assure sa fonction d'amplification, et un mode de test, dans lequel il est reconfiguré en oscillateur et a une fonction de générateur d'un signal sinusoïdal RF utilisable comme signal RF de test ou de calibration. Le mode de fonctionnement est défini par l'état logique d'un signal de commande respectif MODE-LNA et MODE-PA. Par exemple, le mode de test correspond à un état logique à "1". L'état de ces signaux est typiquement configuré par un équipement de test, à travers un port d'interface série (bus SPI, I2C ou autres) du circuit intégré, dans une mémoire volatile (un registre) du circuit intégré.

Egalement, selon un mode de réalisation, le module comprend au moins un circuit de détection DET-A d'une caractéristique d'un signal radiofréquence, qui dans l'exemple est mesuré en un point de la ligne de transmission RF entre le commutateur X2 et le plot P2. Ce circuit de détection est une ressource de test intégrée du module, utilisée pour mesurer une caractéristique du signal sinusoïdal RF généré par l'un ou l'autre des amplificateurs LNA et PA, en mode de test. Une caractéristique mesurée correspond par exemple à une caractéristique basse fréquence (BF) telle qu'une valeur de courant, de tension ou de puissance caractéristique de l'enveloppe BF du signal RF. Typiquement ce circuit de détection est conçu pour présenter une haute impédance d'entrée, pour dériver peu de puissance. Autrement dit, les pertes par insertion sont limitées ou quasi-nulles. Selon un mode de réalisation, ce circuit comprend un convertisseur analogique numérique, de manière à fournir en sortie une donnée numérique DATA-A, qui est une mesure de la caractéristique recherchée. Comme on recherche des ressources à la fois peu coûteuses en surface, faciles à implémenter dans un contexte d'électronique analogique RF et capables de fournir une mesure suffisamment stable et précise, on utilise de préférence un détecteur de tension crête, plutôt qu'un détecteur de courant. Ce choix est également judicieux, car les modules frontaux intègrent souvent de tels détecteurs de tension crête pour faire de la régulation de puissance (obligation réglementaire de respecter les normes de puissance d'émission), en sorte que la ressource est déjà présente et utilisable pour les besoins de l'invention.

La figure 3 illustre à titre d'exemple non limitatif, un mode de réalisation d'un circuit DET_{A} particulièrement simple pour mesurer une amplitude de tension crête. Il est basé sur un circuit de détection de tension crête de type Diode-RC, dont la constante de temps est en pratique adaptée à la fréquence du signal sinusoïdal à détecter, de manière à fournir une tension constante en sortie V_{DC} (la capacité n'a pas le temps de se décharger entre deux crêtes). Un tel circuit diode-RC est très facilement intégrable sans perturber le fonctionnement opérationnel ou sous test du module radiofréquence.

Le circuit Diode-RC est avantageusement suivi d'un convertisseur analogique numérique ADC_{DET} qui fournit en sortie une valeur numérique DATA-A qui représente l'amplitude de tension crête, codée sur quelques bits D0-DI; Cette donnée peut être mémorisée dans une mémoire volatile (registre) associée à l'interface série du module. Le nombre de bits de résolution peut être adapté en fonction de la précision de mesure recherchée, selon la phase ou les spécifications de test, comme on l'expliquera plus loin. En pratique le convertisseur peut être spécifique au circuit de mesure ou une ressource commune (partagée) intégrée au module.

Le circuit DET_{A} constitue une ressource de test intégrée du module FEM (BIST) qui permet, lorsque l'un des amplificateurs PA ou LNA est reconfiguré en oscillateur électronique, de réaliser un auto-test de connexion antennaire, lorsque le plot d'antenne est connecté à une antenne ou une charge d'impédance équivalente comme cela sera décrit plus loin.

D'autres ressources de test peuvent être avantageusement prévues, permettant la mise en œuvre d'autres séquences d'auto-test permettant de qualifier (en gain et/ou en bruit) les voies d'émission et de réception du module, sur la base du signal sinusoïdal généré par l'un des amplificateurs et utilisé comme signal de calibration RF. Le module FEM représenté à la figure 2 comprend ainsi un premier commutateur de rebouclage de voies X_{LP1}, activable en mode de test, permettant de reboucler une sortie de la voie de réception, sur une entrée correspondante de la voie d'émission, ainsi qu'un deuxième circuit détecteur DET-B d'une caractéristique de signal, placé à proximité du plot P1 d'E/S. Dans l'exemple illustré, le commutateur de rebouclage X_{LP1} permet de reboucler la sortie OUT_{RX} du circuit électronique aval RF_{DWN} sur l'entrée IN_{TX} du circuit électronique amont RF_{UP}. D'autres implantations peuvent être envisagées. Par exemple, on peut souhaiter spécifiquement vérifier les caractéristiques des amplificateurs LNA et PA : on peut prévoir un commutateur de rebouclage X'_{LP1} configuré pour reboucler la sortie OUT_{LNA} de l'amplificateur LNA sur l'entrée IN_{PA} de l'amplificateur de puissance PA. Dans ce cas, il faut aussi prévoir un moyen de mesure d'une caractéristique BF du signal en sortie OUT_{LNA} ou en entrée IN_{PA}. Selon les modules, on pourra ainsi avoir une ou plusieurs possibilités de rebouclage permettant une qualification des voies plus ou moins fines. Dans la figure, le chemin de boucle de ces différents commutateurs X_{LP1}, X'_{LP1} et _{XLP2} a été représenté en traits pointillés pour mettre en évidence qu'il s'agit de ressources de test intégrées, prévues pour l'auto-test du module, selon l'invention. Ces ressources n'interviennent pas en opérationnel : elles sont non activées et conçues pour ne pas induire de pertes RF.

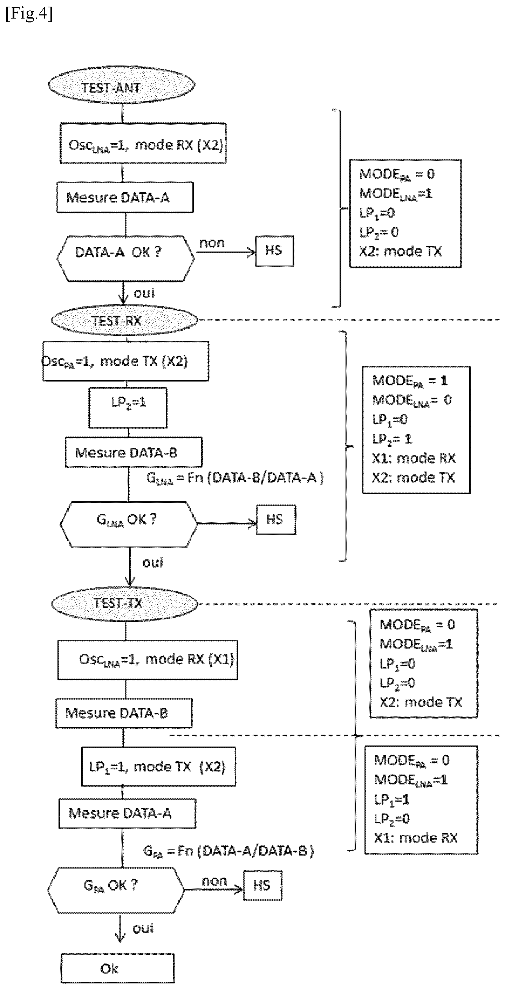

Ces différentes ressources de test intégrées selon l'invention permettent de réaliser une séquence d'auto-test du circuit intégré FEM, permettant de vérifier une connexion antennaire, et/ou évaluer le gain et ou le bruit de la voie de réception radiofréquence (ou de l'amplificateur à faible bruit), et/ou évaluer le gain de la voie d'émission radiofréquence (ou de l'amplificateur de puissance). Plus précisément, une séquence d'auto-test selon l'invention comprendra de préférence comme illustré sur la figure 4, une étape de test de connexion antennaire TEST-ANT ; puis si cette connexion antennaire est validée (bonne adaptation d'impédance), une étape de test, TEST-RX, de la voie de réception RX du module comprenant au moins une mesure du gain (et éventuellement du bruit) de voie de réception et/ou de l'amplificateur à faible bruit LNA, sur la base du signal sinusoïdal émis par l'amplificateur de puissance PA reconfiguré en oscillateur utilisé comme signal de calibration RF ; puis, si la voie de réception RX est validée (gain conforme), une étape de test, TEST-TX, de la voie d'émission TX du module par mesure du gain de voie de réception et/ou de l'amplificateur de puissance, sur la base du signal sinusoïdal émis par l'amplificateur à faible bruit LNA reconfiguré en oscillateur, utilisé comme signal de calibration RF.

Les différentes étapes d'un procédé d'auto-test selon l'invention vont être expliquées ci-après, appliquées en exemple à un module frontal en mode half-duplex, correspondant au schéma-bloc de principe de la figure 4.

### ETAPE DE VERIFICATION DE LA CONNEXION ANTENNAIRE, TEST-ANT

Pour cette vérification, la borne de connexion d'antenne P2 est raccordée ou assemblée à une antenne, ou bien à une charge équivalente Z_{ANT} de l'antenne utilisée dans le produit de destination (terminal) par toute technique appropriée. Selon le type d'antenne et selon la technique d'assemblage du module à l'antenne, il peut être avantageux ou plus simple d'utiliser pour le test, une simple impédance de charge équivalente. Des valeurs courantes de cette impédance sont 50 ou 75 ohms.

Le module FEM sous test étant alimenté, un équipement de test conventionnel vient activer le mode fonctionnel de test de l'amplificateur LNA ou de l'amplificateur PA, permettant de le configurer en oscillateur électronique. Dans l'exemple, c'est l'amplificateur LNA qui est reconfiguré : l'équipement de test utilise l'interface série du module pour positionner dans un registre mémoire un état logique, "1" dans l'exemple, du signal de commande MODE_{LNA} et le commutateur X2 est configuré en mode réception TX (Figure 2), On obtient un signal sinusoïdal RF en entrée IN_{LNA} (et aussi en sortie OUT_{LNA}), dont les caractéristiques (par exemple les caractéristiques BF de l'enveloppe : courant, tension, puissance) dépendent de l'impédance de charge d'antenne vue par l'oscillateur (l'amplificateur LNA). Dans l'exemple d'un détecteur DET_{A} de tension crête (Figure 3), la valeur de tension crête mesurée est une fonction linéaire de l'impédance de charge d'antenne.

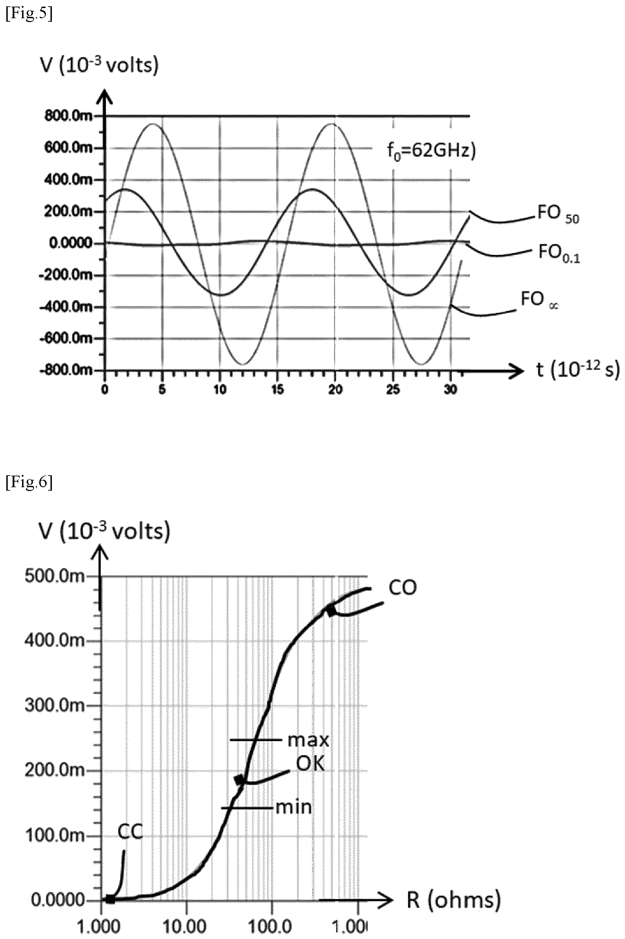

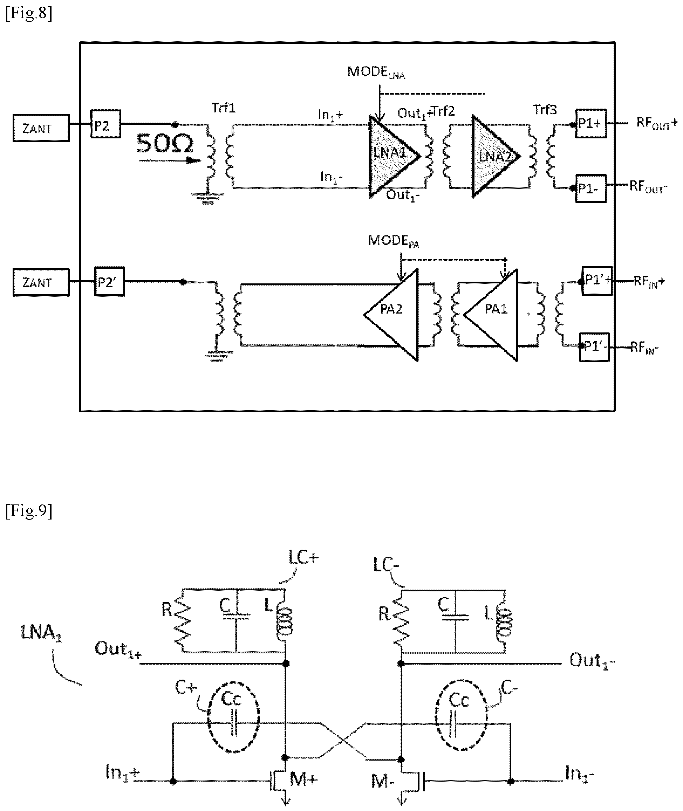

La figure 5 illustre cela. Elle montre des formes d'onde du signal sinusoïdal Sin_{RF} en fonction d'une impédance de charge de sortie représentative d'une charge d'antenne. Ces formes d'onde ont été obtenues par simulation, en utilisant un schéma électronique d'un amplificateur à faible bruit LNA conçu pour un terminal de communication pour la bande dite 60 GHz et pour des impédances d'antenne de 50 ohms. C'est dans l'exemple un amplificateur à paire différentielle à dégénérescence d'inductance, qui est schématiquement représenté à la figure 8. Il comprend deux étages d'amplification LNA1 et LNA2, et l'étage LNA1 qui est l'étage d'entrée, raccordé au plot de connexion d'antenne P2 a été reconfiguré en oscillateur selon le principe de l'invention. On expliquera plus en détails comment on peut réaliser cette reconfiguration en référence aux figures 8 à 10.

Pour les besoins de la simulation, on a raccordé une charge d'impédance variable sur un plot d'antenne raccordé en entrée de cet étage LNA1. Les formes d'onde obtenues correspondent bien à un signal sinusoïdal de fréquence f₀ autour de 62 GHz (période 16 picosecondes environ), correspondant à la fréquence de résonance du circuit LC d'accord de l'amplificateur utilisé, dans la bande utile du module (bande 60 GHz). La forme d'onde FO₅₀ a été obtenue avec une impédance de charge nominale, de 50 Ohms, et présente une tension crête de l'ordre de 300 millivolts, conforme aux attentes. La forme d'onde FO_{0.1} obtenue avec une très faible impédance de charge de l'ordre de 0,1 ohms, simulant un court-circuit à la masse présente une tension crête quasi nulle. La forme d'onde FO∞ obtenue avec une très forte impédance de charge, de l'ordre de 5.10⁹ ohms, simulant un circuit ouvert avec une impédance de charge infinie, présente une tension crête, supérieure à 700 millivolts, ce qui peut, dans certains cas, être trop important et endommager le circuit intégré.

La courbe de la figure 6 met en évidence la variation linéaire de tension crête avec l'impédance de charge. Notamment 3 points de la courbe correspondent respectivement à :
- OK, un état de connexion antennaire conforme, correspondant dans l'exemple à une impédance de charge autour de 50 ohms ;
- CO, un défaut de connexion de type circuit ouvert, correspondant dans l'exemple à une impédance de charge de l'ordre de 5.10⁹ ohms ;
- CC, un défaut de type circuit court-circuité à la masse, correspondant dans l'exemple à une impédance de charge de l'ordre de 0,1 ohms.

On peut donc facilement exploiter cette fonction linéaire pour de déterminer un état de connexion antennaire. On peut notamment le faire au moyen d'un détecteur de tension crête mesurant la tension crête du signal sinusoïdal sur la ligne signal entre l'amplificateur reconfiguré en oscillateur et le plot d'antenne P2 (figures 3 et 4). Un circuit de type Diode-RC est particulièrement intéressant car simple à intégrer, mais on peut envisager des circuits de mesure plus complexes. On pourrait également choisir de mesurer une autre caractéristique BF, et relier la mesure de façon similaire à une charge d'antenne.

L'autre aspect de cette mesure, est que c'est une mesure numérique, facile à récupérer par l'équipement de test, par l'interface série du module. On utilise en pratique un convertisseur ADC_{DET} calibré pour une gamme de tension déterminée pour le module considéré en fonction de l'amplificateur (technologie, structure) et des conditions de polarisation DC de l'amplificateur. On voit par exemple que les conditions de polarisation DC de l'amplificateur utilisées pour la simulation diffèrent entre la figure 5 et la figure 6, ce qui se traduit par une excursion maximale de tension crête différente : de l'ordre de 800 millivolts dans un cas (Figure 5), 500 millivolts dans l'autre (Figure 6).

Ce convertisseur fournit une donnée DATA-A sur un nombre de bits qui dépend de la précision souhaitée : avec plus de bits de résolution, on peut définir une plage plus étroite (valeurs min et max) autour d'une valeur nominale de tension crête, 180 millivolts dans les conditions de la figure 6 par exemple, correspondant à un état de connexion antennaire qui est correct. On peut facilement obtenir l'information recherchée (OK) selon la valeur des bits de la donnée DATA-A, par exemple au moyen d'un petit circuit logique (quelques portes logiques) paramétrable. Egalement, si on veut seulement discriminer entre deux états (OK pas OK) ou trois états (OK, CO, CC) on n'a pas nécessairement besoin de beaucoup de précision et on peut configurer le convertisseur avec une faible résolution, quatre bits de résolution par exemple et selon que l'information inclus le type de défaut ou pas, le résultat du test est codé sur 1 ou 2 bits. Tout ceci concourt à une durée de test réduite et un flux de données en fin de test réduit à un ou deux bits par module, réduisant le temps de lecture pour l'équipement de test ( interface série).

L'invention permet ainsi de qualifier l'état de connexion antennaire de chacun des circuits radiofréquence sous test de manière simple, à faible coût d'intégration (reconfiguration en oscillateur, détecteur, convertisseur) avec un faible flux de données de test (quelques bits par module), très favorable à du test en volume.

En pratique, et comme indiqué ci-dessus concernant les simulations des figures 5 et 6, la phase de test doit être conduite de manière non destructrice, c'est-à-dire sans risquer d'atteindre des niveaux de tension de claquage des transistors de l'amplificateur en cas de défaut de type circuit ouvert. Pour cela, on prévoit avantageusement un paramétrage adéquat des conditions de polarisation DC (courant et/ou tension de polarisation DC) de l'amplificateur reconfiguré en oscillateur. On sait faire cela facilement, via l'interface série. Ces possibilités de réglage sont généralement déjà prévues au moins pour l'amplificateur de puissance de la voie de transmission TX (régulation de la puissance de sortie).

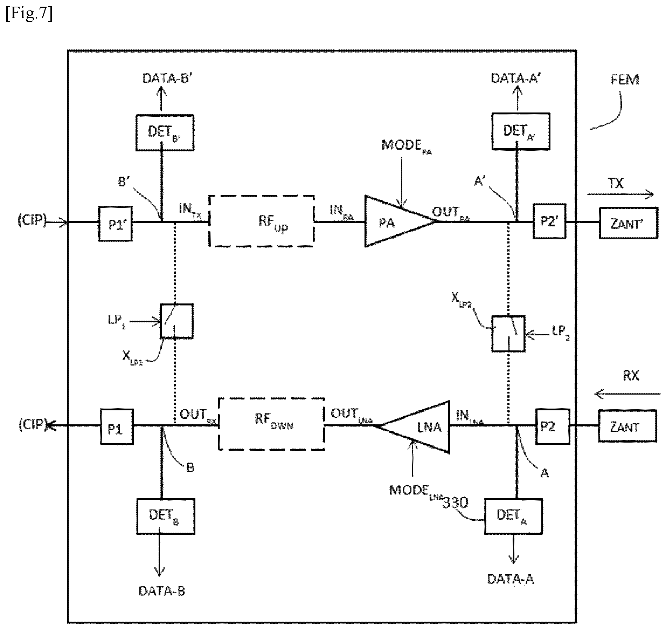

A noter que l'on peut tout aussi bien utiliser l'amplificateur de puissance PA reconfiguré en oscillateur avec un commutateur X2 en mode émission TX (Figures 2 et 4) pour réaliser cette phase de test TEST-ANT, avec des conditions de polarisation DC de l'amplificateur PA adéquates pour ne pas risquer de claquage. D'ailleurs, dans le cas d'un module frontal de type duplex intégral comme schématiquement illustré sur la figure 7, avec des plots d'antenne respectifs pour la réception (P2) et pour l'émission (P'2), on réalisera alors deux séquences TEST-ANT, l'une avec l'amplificateur LNA reconfiguré en oscillateur pour tester la connexion d'antenne de réception, et l'autre avec l'amplificateur PA reconfiguré en oscillateur, pour tester la connexion d'antenne d'émission.

Si la connexion antennaire n'est pas correcte (pas OK), le circuit sous test est rejeté. Si elle est correcte (OK), et l'équipement de test peut passer à l'étape de test suivante, TEST-RX.

ETAPE DE TEST DE LA VOIE DE RECEPTION RX DU MODULE, TEST-RX.

Dans cette étape, on utilise l'amplificateur de puissance PA comme générateur de signal radiofréquence de calibration, en le reconfigurant en oscillateur électronique (MODE_{PA} à "1"), pour obtenir un signal sinusoïdal à une fréquence f0 dans la bande utile de l'amplificateur. Comme la connexion antennaire a été testée, l'excursion de tension crête de ce signal est dans une plage de tension nominale, sans risque de claquage pour les transistors. Il peut néanmoins être intéressant de régler les conditions de polarisation DC (courant et/ou tension) de l'amplificateur de puissance dans cette phase également, pour limiter la puissance du signal de calibration RF dans le but de limiter les contraintes de conception des lignes de rebouclage (y compris commutateurs de rebouclage). On peut alors réduire l'impact surfacique de l'intégration de ces ressources de test dans le module. De préférence, on utilise le circuit de détection DET_{A} (commutateur X2 en mode émission TX) pour mesurer au moins une caractéristique BF (tension crête dans l'exemple) de ce signal de calibration RF dans les conditions du test (température notamment).

Ce signal RF de calibration est ensuite injecté en entrée IN_{LNA} de l'amplificateur LNA de la voie de réception RX, en activant le commutateur de rebouclage X_{LP2} (LP₂ à "1"). On peut alors mesurer la même caractéristique BF du signal en sortie OUT_{RX} de voie de réception, au moyen du circuit de détection DETB (similaire au circuit DET_{A}) (commutateur X1 en mode réception) qui fournit une donnée numérique correspondante DATA-B. Le circuit DET_{B} est similaire au circuit DET_{A}.

Le ratio DATA-B et DATA-A pour les conditions de polarisation DC de l'amplificateur LNA et le signal de calibration RF donne une information de gain. A noter que l'on peut également varier les conditions de polarisation DC de l'amplificateur LNA, pour obtenir plusieurs mesures. L'équipement de test est alors en mesure de déterminer si l'amplificateur LNA est conforme aux spécifications en ce qui concerne le gain.

Dans la conception du module, on peut facilement prévoir d'utiliser le même convertisseur ADC-A pour fournir les mesures DATA-A et DATA-B. Egalement, on peut paramétrer la résolution du ou des convertisseurs (par exemple 8 bits, plutôt que 4), selon la précision recherchée sur la mesure de gain.

On peut avantageusement prévoir une mesure de bruit (facteur de bruit ou rapport signal sur bruit). Dans ce cas, on prévoit en outre au moins une analyse spectrale du signal obtenu en sortie de voie de réception. En mode oscillateur, la fréquence du signal généré peut généralement être contrôlée en modifiant la valeur d'une capacité d'un circuit résonant de l'amplificateur, capacité qui peut par exemple être implémentée sous forme d'un varactor (capacité variable). Cela permet à l'oscillateur d'être contrôlé en fréquence dans une certaine bande. En sortie du récepteur P1, un analyseur de spectre permet de mesurer l'amplitude du signal émis par l'oscillateur pour chaque configuration de fréquence (gain dans la bande) et le plancher de bruit du récepteur, ramenés en bande de base. Ce mode de fonctionnement permet d'éviter l'utilisation fastidieuse de diode de bruit, branchée en entrée du récepteur P2. Ensuite, si les caractéristiques de la voie de réception (et/ou de l'amplificateur LNA) sont conformes aux spécifications, on peut passer à une troisième étape de test TEST-TX, pour vérifier les caractéristiques de gain de la voie d'émission. Sinon, le test s'arrête et le module est rejeté (non conforme).

### ETAPE DE TEST DE LA VOIE DE TRANSMISSION RX DU MODULE, TEST-TX

Dans cette étape, c'est l'amplificateur LNA qui est utilisé en générateur de signal radiofréquence de calibration (MODE_{LNA} à "1") et le commutateur X1 en mode réception RX permet une mesure d'une caractéristique BF du signal de calibration RF obtenu en sortie OUT_{RX} de voie RX, par le détecteur DET_{B} associé (donnée DATA-B).

Ensuite, le commutateur de rebouclage X_{LP1} est activé (LP₁ à "1") permettant d'injecter ce signal de calibration RF obtenu en sortie OUT_{RX}, sur l'entrée IN_{TX} de la voie d'émission TX et le circuit DET_{A} mesure une caractéristique BF correspondante (commutateur X2 en mode émission). Le rapport DATA-A/DATA-B permet à l'équipement de test de déduire un niveau de gain de la voie de d'émission (et/ou de l'amplificateur de puissance selon la position du commutateur de boucle).

Comme pour la phase de test TEST-RX, on peut ajuster la précision du ou des convertisseurs, adapter les conditions de polarisation DC de l'amplificateur LNA utilisé en générateur de signal RF de calibration, et/ou de l'amplificateur PA de la voie d'émission sous test.

Dans les deux phases, on peut choisir de réaliser le rebouclage à différents endroits des voies d'émission et de réception, par exemple au niveau de la sortie de l'amplificateur LNA et de l'entrée de l'amplificateur PA (commutateur X'_{LP1}). En pratique, il faut faire un compromis entre les contraintes d'implémentation des ressources de test (commutateurs de rebouclage et circuits de mesure BF associés) et l'exhaustivité et la précision du test souhaité.

Les ressources d'auto-test intégrées dans les modules frontaux selon l'invention permettent de relâcher les contraintes sur l'équipement de test ATE et de réaliser un test en volume efficace. Toute l'activation et le paramétrage des différentes phases de test, ainsi que la lecture des résultats peuvent être réalisées par l'équipement de test via le port d'interface série et la mémoire volatile associée communément prévus dans les circuits intégrés. L'invention ne se limite cependant pas à cette mise en œuvre et on pourrait aussi prévoir des plots spécifiques d'E/S de signaux logiques, pour le test.

L'invention vient d'être expliquée pour un module frontal de type semi-duplex. Elle s'applique aussi bien à un module frontal à duplex intégral. C'est ce qu'illustre la figure 7. Le module est alors connecté à deux antennes, par deux plots de connexion respectifs P2 (pour la voie de réception) et P'2 (pour la voie d'émission). On a alors deux connexions antennaires à tester, en utilisant comme générateur d'un signal sinusoïdal RF de test, l'amplificateur associé au plot à tester, soit LNA en réception (P2), et PA en émission (P'2).

Les autres phases de test TEST-RX et TEST-TX peuvent se dérouler de manière comme décrit précédemment en référence aux figures 4 à 6 pour un module en semi-duplex, en utilisant un commutateur de rebouclage X_{LP1} et X_{LP2} de chaque côté des voies. Dans l'exemple illustré on prévoit alors un détecteur de caractéristique BF associé à chacun des plots P1 et P1', P2 et P2'. On a vu que par exemple, si on utilise un circuit de détection de tension crête de type D-RC, c'est un circuit très petit, très facile à intégrer. Mais on pourrait utiliser un seul détecteur de chaque côté. Par exemple, pour mesurer le signal IN_{TX} (TEST-TX) ou OUT_{RX} (TEST-RX), on pourrait utiliser un seul et même détecteur, DET_{B}, en activant au besoin le commutateur de boucle X_{LP1}, dans l'exemple, pour le test TEST-RX. De même côté antenne. On peut perdre un peu de précision pour la mesure nécessitant l'utilisation du commutateur de boucle.

L'invention qui vient d'être décrite de manière générale, s'applique à toute technique de communication/modulation RF. On notera à cet égard que dans le cas d'une modulation numérique à quadrature de phase, les circuits RF_{UP} et RF_{DWN} si ils sont présents, comporte chacun une branche par quadrature, et on a donc également un plot d'interface d'E/S avec le circuit de traitement en bande de base (CIP) par quadrature. Dans ce cas, si on souhaite tester les voies complètes d'émission et réception du module, il faut aussi prévoir un détecteur de caractéristique BF par quadrature. On peut optimiser le nombre de détecteurs à intégrer en utilisant les commutateurs de boucle, comme déjà expliqué.

Différents modes de réalisation d'amplificateurs reconfigurables en oscillateur selon le principe de l'invention vont être maintenant donnés en exemple. Il n'est pas possible de lister de manière exhaustive toutes les topologies d'amplificateurs radiofréquence à faible bruit ou de puissance. Elles sont trop nombreuses et dépendent du domaine de fréquence utile, mais on peut distinguer deux grandes catégories : les structures à paire différentielle, très utilisées dans le domaine haute fréquence pour les qualités de stabilités de signal qu'elles apportent ; et les structures non différentielles à montage de transistors de type cascode. On va donc expliquer comment on peut appliquer l'invention pour ces deux types de structure. L'homme du métier saura appliquer les principes qui vont être expliqués aux réalisations pratiques d'amplificateur RF LNA ou PA, en faisant les adaptations nécessaires.

La figure 8 représente un module frontal en duplex intégral, comprenant au principal, les étages amplificateurs à faible bruit d'entrée de voie de réception et les étages amplificateurs de puissance de sorte de voie d'émission, dans une topologie à paire différentielle. Ces topologies sont très utilisées pour la très haute fréquence, par exemple dans la bande 60 Ghz.

Prenons la voie de réception. L'amplificateur à faible bruit est couplé au plot d'antenne P2 par un transformateur d'entrée Trf1 (un balun) qui assure le passage en mode différentiel du signal reçu de l'antenne connectée au plot P2. L'amplificateur à faible bruit comprend au moins deux étages LNA1 et LNA2 (respectivement un étage d'entrée et un étage dit "driver"), permettant d'obtenir les performances de gain et de bruit attendues. L'étage LNA1 est celui qui est raccordé au plot d'antenne P2 (via le balun Trf1). Il a un mode de fonctionnement opérationnel, en amplificateur, et un autre mode de fonctionnement sous test, en oscillateur, selon l'état logique du signal de commande MODE_{LNA}, qui est fixé dans un registre de paramètres de commande du module, via le port d'interface série prévu pour ces fonctions. L'étage LNA1 reçoit des signaux RF en opposition de phase (de Trf1) en entrées In₁+ et In₁-. Il fournit en sortie Out₁+ et Out₁-, un signal différentiel qui est appliqué au primaire d'un deuxième transformateur Trf2 intercalé entre les étages LNA1 et LNA2. L'étage LNA2 fournit à son tour un signal différentiel vers un troisième transformateur Ttrf3, qui assure l'interface différentielle vers une circuiterie aval (intégrée ou pas au module). Dans l'exemple, le secondaire de ce transformateur est relié à des plots respectifs P1+ et P1-, permettant l'interface avec un autre circuit intégré (CIP, figure 1). L'étage LNA2 pourrait être reconfigurable en oscillateur, sur commande par le même signal MODE_{LNA}, mais en pratique ce n'est pas nécessaire, ce qui permet de limiter le nombre de ressources de test à intégrer dans le module.

L'amplificateur de puissance à une topologie duale. Il reçoit un signal RF différentiel d'une circuiterie amont, par des plots d'entrée P'1+ et P'1-. Sa sortie différentielle est couplée au plot d'antenne P2' par un transformateur. L'étage PA2 de sortie qui est celui qui est raccordé au plot d'antenne P'2 (via un balun) a les deux modes de fonctionnement opérationnel (amplificateur) et sous test (oscillateur) selon l'invention, configuré par le signal de commande MODE_{PA} qui est fixé dans le registre de paramètres de commande du module, via le port d'interface série du module. Eventuellement PA1 peut aussi être reconfigurable en oscillateur.

De manière bien connue, pour améliorer le gain et la stabilité, la structure des amplificateurs à paire différentielle intègre généralement une paire croisée de neutrodynage qui a une fonction de contre-réaction en anti-phase, pour contrer l'effet Miller induit par les capacités grille drain des transistors à effet de champ et qui se traduit notamment par des déphasages nuisibles à la stabilité du montage.

La figure 9 montre un tel exemple de topologie à paire différentielle et paire croisée de neutrodynage, appliquée à l'étage LNA1 de la figure 8. Une telle structure est connue et par exemple décrite dans la publication de A. Larie, E. Kerhervé, B. Martineau, V. Knopik, D. Belot, "A 1.2V 20 dBm 60 GHz Power Amplifier with 32.4 dB Gain and 20 % Peak PAE in 65nm CMOS" European Solid State Circuits Conference (ESSCIRC), 2014 IEEE, 22-26 Sept. 2014.

La paire différentielle est formée par deux transistors à effet de champ M+ et M-identiques montés en source commune. Un premier condensateur de neutrodynage C+ est connectée entre la sortie Out₁- (drain du transistor à effet de champ M-) et l'entrée In₁+ (grille du transistor à effet de champ M+) et un autre condensateur de neutrodynage C- est connectée entre la sortie Out₁+ (drain du transistor à effet de champ M+) et l'entrée In₁- (grille du transistor à effet de champ M-). Les deux condensateurs sont identiques, de capacité Cc. Ces capacités peuvent être réalisées sous forme d'éléments passifs discrets (condensateurs) ; mais ils sont le plus souvent réalisés par un transistor dont on a court-circuité ensemble le drain et la source, formant une première électrode, l'autre électrode étant constituée par la grille du transistor. On parle de capacité "MOS" et les valeurs de ces capacités conviennent bien pour ces fonctions de neutrodynage. La capacité MOS équivalente est égale à la somme des capacités grille-source Cgs et grille-drain Cgd des transistors.

Par ailleurs, chacune des sorties Out₁+ et Out₁- de l'étage est chargé par un circuit résonant respectif LC+ et LC- correspondant au primaire du transformateur de sortie Trf2 qui par conception, sont des circuits résonant à une fréquence caractéristique f₀ (fonction de L et C) qui est dans la bande de fréquence utile (dans l'exemple dans la bande dite 60 Ghz (typiquement 57-66 GHz). Par exemple f₀ a une valeur autour de 62 Ghz. Les deux circuits résonant LC1 et LC2 sont identiques, aux facteurs de dispersion près, fonction de la technologie et les notations R, L et C sur la figure représentent les valeurs de résistance, capacité et inductance équivalentes incluant les résistances et capacités parasites.

Pour reconfigurer un tel étage amplificateur en oscillateur, comme on dispose déjà des boucles de contre-réaction de neutrodynage, on propose de façon tout à fait avantageuse d'utiliser un transistor à effet de champ M_{Cc} pour réaliser la capacité de neutrodynage dans chaque branche de la paire croisée, mais dans un montage série en interrupteur, entre la grille d'un des transistors de la paire différentielle (M- par exemple) et le drain de l'autre transistor de cette paire (M+ dans l'exemple). Chaque transistor M_{Cc} est commandé (sur sa grille) par le signal MODE_{LNA}. En mode bloqué, sa capacité équivalente Cₜ devient Ct = Cds + (Cgs x Cgd)/(Cgs + Cgd), fonction des capacités drain-source Cds, grille drain Cgd et grille source Cgs du transistor T_{Cc} et on s'arrange pour qu'elle soit égale à la valeur Cc de neutrodynage prédéfinie (dimensionnement adéquat du transistor). L'état logique "0" du signal MODE_{LNA} détermine alors le mode de fonctionnement standard de l'étage LNA1. Dans l'exemple de transistors FET à canal N, à l'état "0", les transistors M_{Cc} sont non passants et assurent la fonction de capacité de neutrodynage. L'étage LNA1 assure alors une fonction d'amplificateur.

A l'état "1", les transistors M_{Cc} sont passants à saturation, équivalents à un court-circuit (faible résistance Rₒₙ), formant dans la structure une paire croisée assurant une réaction positive, base d'un fonctionnement en oscillateur électronique à la fréquence caractéristique f₀ du circuit résonant LC. On retrouve en entrée et en sortie, un signal sinusoïdal à la fréquence f0 qui est transmis sur le plot P2 de connexion d'antenne (figure 8)et également au LNA2 et à la suite de la chaîne de réception. C'est ce signal qui est utilisé selon l'invention comme signal de test RF (TEST-ANT) pour vérifier/qualifier la connexion antennaire pour la bande de fréquence opérationnelle de module, lorsque le plot P2 est raccordé à une antenne ou une charge équivalente ZANT ; et c'est ce signal que l'on peut aussi utiliser comme signal de calibration RF pour tester la voie d'émission comme expliqué précédemment (TEST-TX).

De préférence le signal de commande MODE_{LNA} est appliqué sur la grille des transistors à effet de champ T_{Cc} à travers une résistance R_{Cc}, de manière à éviter, lorsque ces transistors se comportent en capacité de neutrodynage (mode opérationnel), que les signaux radiofréquence puissent être court-circuités à la masse. En pratique, la résistance doit être suffisamment forte, c'est-à-dire en pratique, avoir une valeur égale ou supérieure à 1 KOhms.

Ainsi, l'étage LNA1 comprend une paire de circuits MC+, MC- (un transistor FET M_{Cc} et une résistance R_{Cc}), qui agit comme paire croisée simple ou de neutrodynage selon le mode de fonctionnement commandé par le signal MODE_{LNA}.

Dans une variante, on peut prévoir que chacun des étages de l'amplificateur LNA (LNA1 et LNA2 dans l'exemple) comprend une telle paire de circuits MC+ et MC-, pilotés par le même signal de commande MODE_{LNA}.

Tout ce qui vient d'être dit pour un amplificateur faible bruit s'applique de la même façon, à un amplificateur de puissance à paire différentielle (remplacement de la paire de capacités de neutrodynage par une paire de circuits à transistor commandé).

Le mode de réalisation proposé est particulièrement avantageux car on a vu qu'en pratique, les capacités de neutrodynage sont généralement réalisées par des transistors. Autrement dit l'implémentation proposée ne remet pas en cause toute la conception/topologie de l'étage amplificateur notamment eu égard aux considérations RF (couplages).

La structure de l'amplificateur LNA et/ou PA peut aussi être une structure non différentielle. Dans ce cas, il faut ajouter à la topologie de base, un circuit commandé (par exemple un transistor à effet de champ commandé sur sa grille par un signal de commande d'auto-test, de préférence au travers d'une forte résistance) dans une boucle d'oscillateur électronique.

On connait différents schémas d'oscillateur électronique, notamment l'oscillateur de Colpitts et de Hartley. Dans l'oscillateur Colpitts, la fréquence d'oscillation est déterminée par deux condensateurs et une inductance, et dans l'oscillateur de Hartley, la fréquence d'oscillation est déterminée par deux inductances et un condensateur. On s'intéresse plus particulièrement à la structure de Colpitts et on va montrer que l'on peut aisément réaliser un tel oscillateur, sur commande dans une étage d'amplificateur LNA ou PA à structure non différentielle.

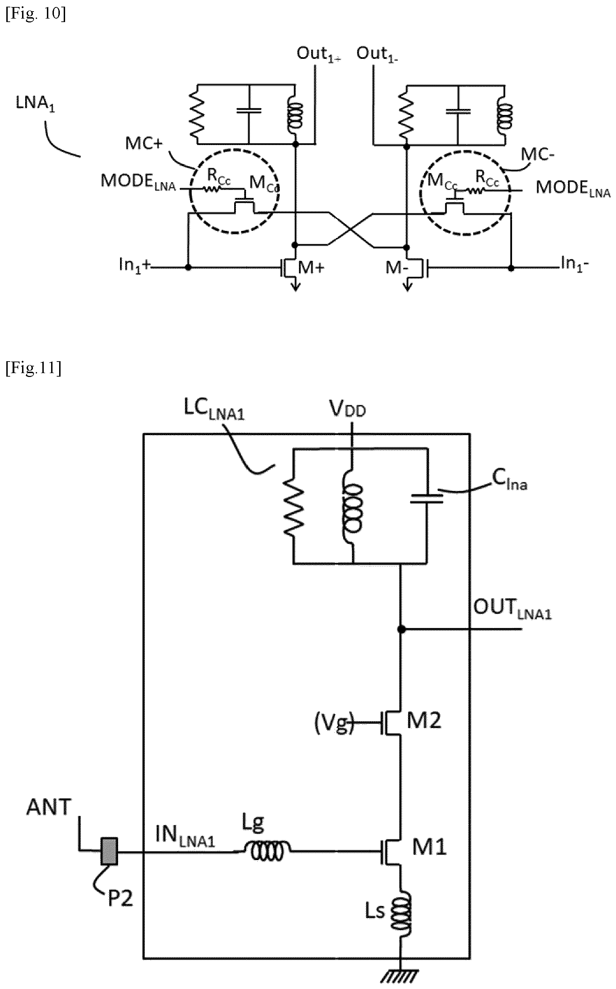

La figure 11 représente une structure connue d'un étage amplificateur LNA, du type à montage en source commune, dans un exemple de topologie à dégénérescence inductive de source ("*inductive source degeneration*"). Ce type de montage est très utilisé en radiofréquence car il offre de très bonnes performances en bruit. Un tel montage est détaillé par exemple dans le document D. K. Shaeffer and T. H. Lee, "A 1.5-V, 1.5-GHz CMOS low noise amplifier," in IEEE Journal of Solid-State Circuits, vol. 32, no. 5, pp. 745-759, May 1997.

Le signal RF provenant du plot d'antenne P2 est appliqué à travers une première inductance Lg sur la grille d'un transistor à effet de champ M1 (transistor d'entrée) qui est monté en source commune, à travers une deuxième inductance Ls. Lg et Ls facilitent l'adaptation d'impédance en entrée. Ce transistor M1 est connecté en série à un transistor de polarisation en courant, M2, commandé à saturation (tension logique VDD appliqué sur sa grille), à l'état passant, équivalent à une faible résistance. Le nœud de sortie de l'amplificateur est formé par le drain du transistor M2 et il est chargé par un circuit résonant LC_{LNA1}, formé principalement d'éléments passifs discrets, dont les valeurs d'inductance Lₗₙₐ et de capacité Cₗₙₐ sont dimensionnées en fonction de la bande utile de fonctionnement, pour résonner à une fréquence f₀ à l'intérieur de cette bande. La résistance représentée symboliquement représente les résistances parasites inhérentes à la structure.

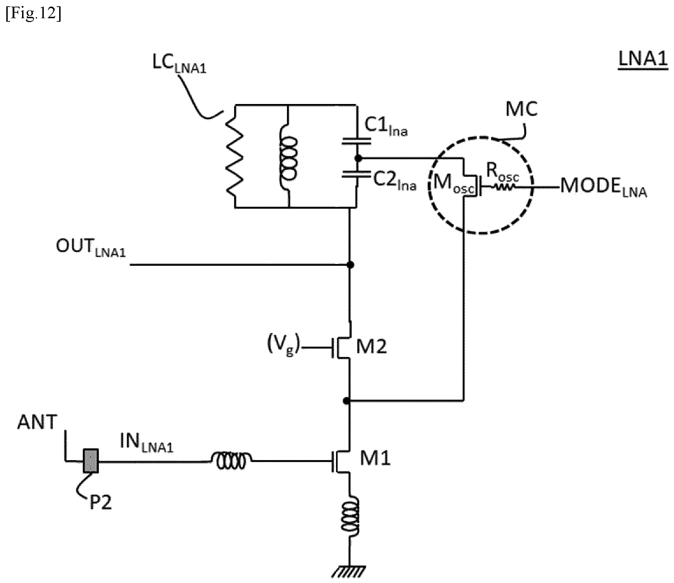

Selon l'invention, comme illustré sur la figure 12, la capacité Cₗₙₐ est réalisée en utilisant non pas un seul élément condensateur, mais deux éléments, C1ₗₙₐ et C2ₗₙₐ en série, dont les valeurs de capacité respective c1 et c2 sont telles que la capacité équivalente du montage série, (c1 x c2)/(c1+c2), égale la valeur de capacité du condensateur Cₗₙₐ du circuit résonant LC_{LNA1} ; et un circuit de commande MC_{LNA} basé sur un transistor à effet de champ M_{OSC} configuré en interrupteur commandé par le signal MODE_{LNA}. Ce transistor M_{OSC} est connecté entre le point de connexion entre les deux condensateurs C1ₗₙₐ et C2ₗₙₐ d'une part, et un point de connexion entre les deux transistors M1 et M2 d'autre part.

En mode opérationnel (MODE_{LNA} à "0"), M_{OSC} est équivalent à une capacité Ct (comme déjà décrit supra), en sorte que la boucle de réaction est ouverte, et n'a pas d'incidence sur le fonctionnement en amplificateur dans la bande passante utile.

En mode d'autotest (OSC_{LNA} à "1"), M_{OSC} est équivalent à une faible résistance, fermant (donc activant) la boucle de contre-réaction : l'amplificateur est alors reconfiguré en oscillateur électronique, à la fréquence de résonnance du circuit résonant LC_{LNA1}. Le schéma électrique correspond alors à celui d'un oscillateur Collpitts.

Il est intéressant de noter que, dans le mode de réalisation de la figure 12, la boucle de réaction positive qui permet de reconfigurer l'amplificateur en oscillateur ne relie pas, à proprement parler, la sortie de l'amplificateur à son entrée. Plutôt, un point situé avant la sortie (le nœud entre les condensateurs C1ₗₙₐ et C2ₗₙₐ) est relié par l'interrupteur commandé M_{osc} à un point situé après l'entrée (le nœud entre les transistors amplificateurs M1 et M2). Par ailleurs, on remarque que le signal oscillatoire est présent sur la sortie de l'amplificateur LNA, mais non sur son entrée (la grille de M1) car, justement, le rebouclage se fait en aval de cette entrée. Dans d'autres modes de réalisation (voir par exemple la figure 10), il est possible que le signal oscillatoire soit présent à l'entrée de l'amplificateur mais pas ou peu sur sa sortie.

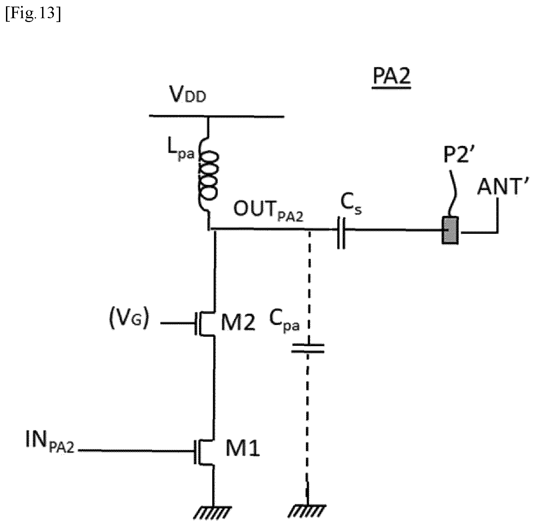

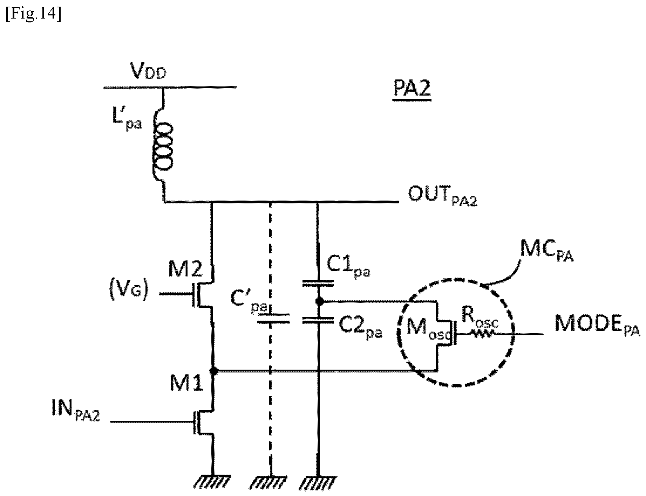

Les figures 13 et 14 montrent une transformation équivalente réalisée dans une structure non différentielle de type cascode d'un amplificateur de puissance, qui correspond à une structure décrite dans la publication de T. Sowlati and D. Leenaerts, "A 2.4 GHz 0.18 /spl mu/m CMOS self-biased cascode power amplifier with 23 dBm output power," 2002 IEEE International Solid-State Circuits Conference. Digest of Technical Papers (Cat. No.02CH37315), San Francisco, CA, USA, 2002, pp. 294-467 vol.1.

La figure 13 illustre la structure de départ de l'étage PA2. Elle comprend deux transistors M1 et M2 en série. Un signal RF provenant d'une circuiterie électronique amont (un précédent étage amplificateur par exemple) est appliqué en entrée IN_{PA2} sur la grille du transistor M1 monté en source commune et le drain du transistor M2 fournit le signal en sortie OUT_{PA2}. Le circuit résonant d'accord de la charge de sortie est ici formé par une inductance Lₚₐ connectée au drain du transistor M2 et la capacité Cₚₐ parasite de sortie de l'étage PA2. Lₚₐ est dimensionnée en fonction de Cₚₐ pour obtenir une fréquence de résonnance f0 déterminée, dans la bande utile de fonctionnement de l'amplificateur. Un condensateur Cₛ est généralement prévu en sortie de l'étage pour réaliser une capacité de couplage dont la fonction est d'éviter une injection de courant continu vers l'antenne.

Selon un mode de réalisation de l'invention, et comme illustré sur la figure 14, on transforme cette structure pour réaliser une boucle de réaction commandée permettant une reconfiguration de l'étage amplificateur en oscillateur électronique, en intégrant une branche de deux condensateurs C1ₚₐ et C2ₚₐ en série en parallèle sur la sortie OUT_{PA2} de l'étage. On peut alors intégrer comme précédemment un circuit commandé MC_{PA} comprenant un transistor à effet de champ M_{osc} configuré en interrupteur commandé par un signal MODE_{PA}, de préférence au travers d'une résistance R_{osc}, entre un point de connexion entre les deux condensateurs C1ₚₐ et C2ₚₐ d'une part, et le point de connexion entre les deux transistors M1 et M2 d'autre part.

En mode opérationnel (MODE_{PA} à "0"), le transistor M_{OSC} est équivalent à une capacité (Ct), et la boucle de réaction est ouverte, inactive, sans incidence sur le fonctionnement en amplificateur dans la bande passante utile. En mode d'autotest (MODEPA à "1"), le transistor M_{OSC} est équivalent à une faible résistance, activant la boucle de réaction (boucle fermée) : l'amplificateur est alors reconfiguré en oscillateur électronique (Colpitts), à la fréquence f₀ de résonnance du circuit résonnant. L'inductance du circuit résonant est alors adaptée à une valeur L'na qui tient compte de la mise en parallèle de la capacité parasite Cₚₐ de l'étage avec les deux condensateurs C1ₚₐ et C2ₚₐ en série.(on fait l'hypothèse que la valeur de Cₚₐ est inchangée).

Ces différents exemples montrent que l'invention peut être facilement implémentée dans les topologies courantes d'amplificateurs utilisés en radiofréquence, aussi bien pour des amplificateurs à faible bruit que des amplificateurs de puissance, et de manière très imbriquée avec la circuiterie opérationnelle.

La description met en évidence que l'invention est facile à implémenter, et peu coûteuse. L'implémentation est d'autant plus aisée et avantageuse dans les structures différentielles, car elle utilise une boucle de contre-réaction déjà présente dans la topologie de l'amplificateur sans ajout d'éléments actifs supplémentaires (capacités de neutrodynage en général réalisées par des transistors) ce qui est optimal en termes de conception et de surface. Notamment il n'y a pas à redimensionner les éléments du circuit d'accord de la charge en sortie. Mais ces exemples montrent aussi qu'il est facile d'ajouter une boucle de réaction permettant de réaliser une topologie d'oscillateur électronique, par exemple de type Colpitts, qui minimise la surface d'implémentation et les coûts d'adaptation (conception) associés.

L'invention a été décrite en référence à un certain nombre de modes de réalisation, mais elle ne s'y limite pas. Par exemple :
- L'amplificateur reconfiguré en oscillateur, qu'il s'agisse d'un amplificateur à bas bruit ou de puissance, peut, en fonction de sa topologie, générer un signal RF sur son entrée, sur sa sortie ou sur les deux.
- Dans les modes de réalisation décrits en détail plus haut, les amplificateurs sont reconfigurés en oscillateurs grâce à un rebouclage « intrinsèque », c'est-à-dire obtenu en modifiant de manière opportune leur structure interne. Il est également possible de prévoir un rebouclage « extrinsèque », en ajoutant un chemin de rebouclage ouvert ou fermé au moyen d'un interrupteur commandé (typiquement un transistor) qui ne joue aucun rôle dans le fonctionnement « normal » de l'amplificateur.
- Il n'est pas nécessaire que tous les tests décrits en référence à la figure 4 soient effectués, et encore moins qu'ils soient effectués dans cet ordre. Par exemple il est possible de tester d'abord les modules frontaux (tests RX et/ou TX) avant de les connecter à des antennes respectives, puis éventuellement de tester la connexion d'antenne.
- Il est possible d'ajouter des fonctions destinées à être utilisées uniquement dans une phase de pré-industrialisation, pour tester ou caractériser les premiers modules frontaux fabriqués. Par exemple, comme cela a été évoqué plus haut, il est possible d'effectuer une analyse spectrale en prévoyant dans le LNA un varactor pilotable, ce qui permet d'obtenir un oscillateur à fréquence variable. Un analyseur de spectre permet alors de mesurer le rapport signal sur bruit de la chaîne de réception en fonction de la fréquence.
- Dans le cas du circuit de la figure 8, où l'amplification des signaux reçus est assurée par deux LNA connectés en cascade (LNA1, dont l'entrée est reliée à l'antenne, et LNA2, dont l'entrée est reliée à la sortie de LNA2), on a considéré le cas où c'est le premier amplificateur (LNA1) qui est reconfiguré en oscillateur, et que le signal RF prélevé à son entrée est utilisé pour tester la connexion d'antenne. Cependant, dans la plupart des cas, un signal RF est également présent à la sortie de LNA1, et ce signal est amplifié par LNA2. Or, l'impédance présente à l'entrée de LNA1 affecte également le signal RF présent à sa sortie. Par conséquent, la connexion d'antenne peut également être testée en effectuant une mesure sur le signal prélevé à la sortie de LNA2, qui présente l'avantage d'être plus intense que le signal à l'entrée de LNA1. Il est également possible d'effectuer deux mesures, l'une à l'entrée de LNA1 et l'autre à la sortie de LNA2, et d'en déduire l'impédance rapportée au plot P2.
- D'autres circuits de mesure peuvent être utilisés à la place du circuit de mesure de tension crête DET_{A} pour acquérir une caractéristique basse fréquence d'un signal radiofréquence présent sur une entrée ou une sortie de l'amplificateur reconfiguré en oscillateur. On peut citer à titre d'exemple :
- Un détecteur de puissance relié à un coupleur RF, voir par exemple J. Gorisse et al. « A 60 GHz CMOS RMS Power Detector for Antenna Impedance Mismatch Detection » Northeast Workshop on Circuits and Systems, Juin 2008, Montréal, Canada.pp.8018.
- Un réflectomètre, voir par exemple H. Chung et al. « A 0.001 - 26 GHz Single-Chip SiGe Reflectometer for Two-Port Vector Network Analyzers », 017 IEEE MTT-S International Microwave Symposium (IMS) (2017): 1259-1261.
- La caractérisation d'une connexion d'antenne, ou plus généralement d'une (dés)adaptation d'impédance, peut également être obtenue autrement que par la mesure d'une caractéristique basse fréquence du signal RF sur un port de l'amplificateur reconfiguré en oscillateur. Par exemple, il est connu de détecter une désadaptation d'impédance, voir par exemple US 2016-0211813.

Comme cela a été évoqué plus haut, il est plus généralement possible de mesurer un signal généré suite à propagation du signal radiofréquence dans au moins un composant du circuit intégré, autre que l'amplificateur reconfiguré en oscillateur, afin d'en déduire des caractéristiques de ce composant. Par exemple, si le signal radiofréquence est généré par un amplificateur à bas bruit reconfiguré en oscillateur, il est possible d'en mesurer la puissance, la distorsion ou le rapport signal sur bruit du signal radiofréquence après qu'il ait traversé les autres composants de la voie de réception ou encore, pourvu qu'un rébouclage approprié soit prévu, la voie d'émission. Réciproquement, si le signal radiofréquence est généré par un amplificateur à bas bruit reconfiguré en oscillateur, il est possible d'en mesurer la puissance, la distorsion ou le rapport signal sur bruit du signal radiofréquence après qu'il ait traversé la voie de réception.

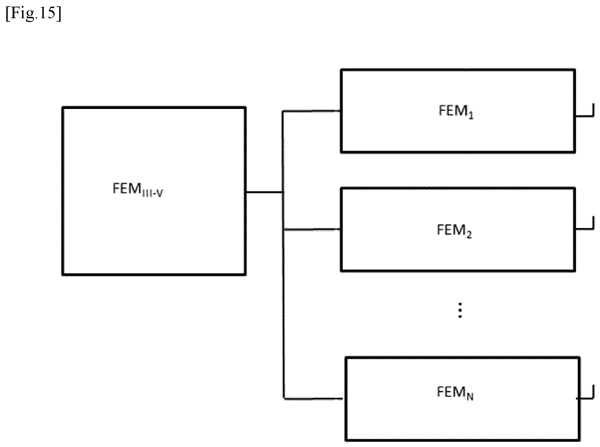

Au lieu d'être directement relié à une antenne le module frontal peut, par exemple, être connecté à un ou plusieurs autres modules frontaux, ces derniers étant reliés à une ou plusieurs antennes. Par exemple, dans le cas de la figure 15, il est prévu un module frontal « amont » FEM_{III-V} de forte puissance, réalisé en technologie III-V - particulièrement adaptée pour une telle application. Ce module amont est relié à une pluralité de modules « aval » FEM₁, FEM₂, ... FEMₙ en technologie CMOS (moins apte à gérer des puissances élevées, mais permettant des niveaux d'intégration plus élevés, et donc des traitement de signal plus sophistiqués), reliés chacun à une antenne respective. Les modules frontaux « aval » réalisent une pluralité de voies d'émission/réception et sont reliés au plot P2 (qui peut éventuellement être dédoublé en un plot d'émission et un plot de réception) par une ligne de transmission multiplexée, permettant d'assurer la distribution des signaux RF avec une adaptation d'impédance de 50 Ohm de part et d'autre.

## Revendications

1. Circuit intégré d'émission et/ou réception radiofréquence (FEM) comprenant au moins un amplificateur (LNA, PA) de signal radiofréquence, ledit au moins un amplificateur étant configuré en mode opérationnel pour réaliser une fonction d'amplification d'un signal radiofréquence appliqué en entrée, ledit amplificateur étant configuré pour réaliser une fonction d'oscillateur dans un mode d'auto-test du circuit intégré, pour générer un signal radiofréquence (Sin_{RF}) sur au moins une de l'entrée ou de la sortie dudit amplificateur, le circuit intégré étant configuré pour permettre, dans ledit mode d'auto-test, la propagation dudit signal radiofréquence dans au moins un composant dudit circuit intégré radiofréquence, distinct dudit amplificateur, et en ce qu'il comprend également au moins un circuit de mesure (DET_{A}, DET_{B}) d'un signal généré suite à propagation dudit signal radiofréquence dans ledit composant dudit circuit intégré, ledit au moins un circuit de mesure étant adapté pour déduire au moins une caractéristique dudit composant, ledit au moins un amplificateur (LNA, PA) comprenant un transistor à effet de champ (M_{Cc}, M_{osc}) commandé en interrupteur par un signal de commande de mode de fonctionnement (MODE_{LNA}), ledit transistor à effet de champ commandé en interrupteur formant une boucle de réaction entre deux nœuds de l'amplificateur, ladite boucle étant ouverte, correspondant à un mode bloqué dudit transistor, en mode opérationnel, et fermée, correspondant à un mode passant dudit transistor en mode d'auto-test.

2. Circuit intégré selon la revendication 1, dans lequel ledit au moins un circuit de mesure est un circuit de mesure (DET_{A}, DET_{B}) d'une caractéristique basse fréquence dudit signal radiofréquence.

3. Circuit intégré selon la revendication 2, dans lequel ledit au moins un circuit de mesure (DET_{A}, DET_{B}) est un circuit de mesure de tension crête.

4. Circuit intégré selon l'une des revendications 1 à 3 comprenant une voie de réception ayant au moins un premier étage amplificateur (LNA1) et une voie de transmission ayant au moins un dernier étage amplificateur (PA2), dans lequel ledit au moins un amplificateur de signal radiofréquence est le premier étage amplificateur (LNA1) de la voie de réception ou le dernier étage amplificateur (PA2) de la voie de d'émission et est couplé, par son entrée ou sa sortie, à un plot de connexion d'antenne (P2).

5. Circuit intégré selon l'une quelconque des revendications 1 à 4, dans lequel ledit transistor à effet de champ commandé en interrupteur forme la boucle de réaction entre un nœud couplé à la sortie de l'amplificateur et un nœud couplé à son entrée.

6. Circuit intégré selon l'une des revendications 1 à 5, dans lequel ledit au moins un amplificateur est à paire différentielle et dans lequel la boucle de réaction comprend le transistor à effet de champ commandé en interrupteur connecté entre une entrée non- inverseuse et une sortie inverseuse de la paire différentielle, le circuit intégré comprenant une deuxième boucle de réaction comprenant un deuxième transistor à effet de champ commandé en interrupteur par le signal de commande de mode de fonctionnement et connecté entre une entrée inverseuse et une sortie non-inverseuse de la paire différentielle, où chacun des deux transistor à effet de champ commandé en interrupteur forme une capacité de neutrodynage (Cc) en mode opérationnel et un court-circuit en mode d'auto-test du circuit intégré configurant alors ledit amplificateur en oscillateur électronique.

7. Circuit intégré selon l'une des revendications 1 à 4, dans lequel ledit au moins un amplificateur est du type non différentiel et comprend :
- un premier transistor à effet de champ (M1) monté en source commune et dont une électrode de grille forme une entrée de signal (IN_{LNA1}) de l'amplificateur, en série avec un deuxième transistor à effet de champ (M2) dont une électrode de drain (d) forme un nœud de sortie de signal (OUT_{LNA1}) de l'amplificateur,
- un circuit résonant (LC_{LNA1}) d'accord de charge du nœud de sortie (OUT_{LNA1}), comprenant deux condensateurs en série (C1ₗₘₐ, C2ₗₙₐ), et
- la boucle de réaction commandée par le signal logique de commande de mode de fonctionnement , la boucle de réaction comprenant le transistor à effet de champ commandé en interrupteur connecté entre un nœud de connexion entre lesdits premier et deuxième transistors à effet de champ et un nœud de connexion entre les deux condensateurs.

8. Circuit intégré selon la revendication 4, dans lequel ledit premier étage amplificateur (LNA1) de la voie de réception (RX) et ledit dernier étage amplificateur (PA2) de la voie d'émission (TX) ont chacun une fonction d'amplification en mode opérationnel et une fonction d'oscillateur en mode d'auto-test du circuit intégré, commandé par un signal de commande mode respectif (MODE_{PA}, MODE_{LNA}).

9. Circuit intégré selon la revendication 8, comportant en outre des moyens de rebouclage (X_{LP2}) d'une sortie (OUT_{PA}) de voie d'émission (TX) sur une entrée (IN_{LNA}) de voie de réception (RX) et au moins un circuit de mesure (DET_{B}) d'une caractéristique basse fréquence de signal en sortie de voie de réception (RX).

10. Circuit intégré selon la revendication 9, comportant en outre des moyens de rebouclage (X_{LP1}) d'une sortie de voie de réception (RX) sur une entrée de voie d'émission (TX) et un circuit de mesure (DET_{A}, DET'_{A}) d'une caractéristique basse fréquence du signal mesuré en sortie de voie d'émission.

11. Circuit intégré selon l'une quelconque des revendications 1 à 10, dans lequel le ou les circuits de mesure de caractéristique basse fréquence comprennent un circuit de détection de tension crête associé à un convertisseur analogique numérique respectif ou partagé.

12. Procédé d'auto-test d'un circuit intégré radiofréquence selon l'une quelconque des revendications 1 à 11, comprenant les étapes suivantes :
a) configurer le au moins un amplificateur (LNA, PA) de signal radiofréquence en oscillateur, pour générer un signal radiofréquence (Sin_{RF}) sur au moins une de l'entrée ou de la sortie dudit au moins un amplificateur;
b) propager ledit signal radiofréquence dans au moins un composant dudit circuit intégré radiofréquence, distinct dudit au moins un amplificateur ; et
c) mesurer un signal généré suite à propagation dudit signal radiofréquence dans ledit composant dudit circuit intégré, et en déduire au moins une caractéristique dudit composant.

13. Procédé selon la revendication 12 dans lequel l'étape c) comprend la mesure d'une caractéristique basse fréquence dudit signal radiofréquence.

14. Procédé selon la revendication 13 dans lequel l'étape c) comprend également la détermination d'une impédance de charge du au moins un amplificateur lorsque son entrée ou sa sortie est reliée à une antenne ou à une charge d'impédance équivalente (Z_{ANT}).

15. Procédé selon l'une des revendications 12 à 14 dans lequel le circuit intégré comprend une voie de réception ayant au moins un premier étage amplificateur (LNA1) et une voie de transmission ayant au moins un dernier étage amplificateur (PA2), dans lequel ledit au moins un amplificateur de signal radiofréquence est le premier étage amplificateur (LNA1) de la voie de réception ou le dernier étage amplificateur (PA2) de la voie de d'émission et est couplé, par son entrée ou sa sortie, à un plot de connexion d'antenne (P2) ; le procédé comprenant une étape de test de connexion d'antenne comprenant :
- la connexion d'une antenne ou d'une charge d'impédance équivalente (Z_{ANT}) sur ledit plot de connexion d'antenne,
- l'activation d'un signal de commande (MOSE_{LNA}), pour commander une reconfiguration en oscillateur électronique d'un étage amplificateur couplé au dit plot d'antenne, qui est le premier étage amplificateur de la voie de réception ou le dernier étage amplificateur de la voie d'émission, et
- la mesure d'une caractéristique basse fréquence d'un signal mesuré entre ledit au moins un étage amplificateur et ledit plot de connexion d'antenne (P2), représentative d'une impédance de charge d'antenne, permettant de discriminer entre une bonne et une mauvaise connexion antennaire.

16. Procédé selon la revendication 15, le circuit intégré radiofréquence comprenant en outre des premiers moyens de rebouclage (X_{LP2}) de la sortie dudit dernier étage amplificateur (PA2) de la voie d'émission en entrée dudit premier étage amplificateur (LNA1) de la voie de réception, et au moins un circuit de mesure (DET_{B}) d'une caractéristique BF de signal mesuré sur une sortie de la voie de réception, le procédé de test comportant en outre une étape de vérification de la voie de réception (TEST-RX) comportant les étapes suivantes :
- activation d'un signal de commande (MOSE_{PA}), pour commander une reconfiguration en oscillateur électronique dudit dernier étage amplificateur (PA2) de la voie d'émission, pour générer un signal sinusoïdal de calibration RF en sortie,
- activation desdits premiers moyens de rebouclage (X_{LP2}) pour injecter ledit signal de calibration RF en entrée dudit premier étage amplificateur de la voie de réception, et
- mesure d'une caractéristique BF dudit signal de calibration RF et d'un signal correspondant délivré en sortie de la voie de réception, pour établir un gain de voie de réception.

17. Procédé selon la revendication 16, comportant une étape supplémentaire d'analyse spectrale du signal délivré en sortie de voie de réception, pour établir un niveau de bruit de la voie de réception.

18. Procédé selon l'une des revendications 15 à 17, le circuit intégré radiofréquence comprenant en outre des deuxièmes moyens de rebouclage (X_{LP1}) d'une sortie de voie de réception sur une entreé de la voie d'émission, le procédé d'auto-test comportant en outre une étape de vérification de la voie d'émission (TEST-TX) comportant les étapes suivantes :
- activation d'un signal de commande (MODE_{LNA}), pour commander une reconfiguration en oscillateur électronique dudit premier étage amplificateur (LNA1) de la voie d'émission, pour générer un signal sinusoïdal RF dans ladite voie de réception et obtenir un signal de calibration RF en sortie de ladite voie,
- activation desdits deuxièmes moyens de rebouclage (X_{LP1}) pour injecter ledit signal de calibration RF en entrée de voie d'émission, et
- mesure d'une caractéristique BF dudit signal de calibration RF et d'un signal correspondant délivré en sortie de la voie d'émission, pour établir un gain de voie d'émission.

## Patentansprüche

1. Integrierter Funkfrequenz-Schaltkreis zum Senden und/oder Empfang (FEM), beinhaltend mindestens einen Funkfrequenzsignal-Verstärker (LNA, PA), wobei der mindestens eine Verstärker im Betriebsmodus konfiguriert ist, um eine Verstärkungsfunktion eines Funkfrequenzsignals durchzuführen, die am Eingang angewendet wird, wobei der Verstärker konfiguriert ist, um eine Oszillatorfunktion in einem Selbsttest des integrierten Schaltkreises durchzuführen, um ein Funkfrequenzsignal (Sin_{RF}) an mindestens einem des Eingangs oder des Ausgangs des Verstärkers zu erzeugen, wobei der integrierte Schaltkreis konfiguriert ist, um in dem Selbsttestmodus die Ausbreitung des Funkfrequenzsignals in mindestens einer Komponente des integrierten Funkfrequenz-Schaltkreises zu erlauben, die sich von dem Verstärker unterscheidet, und dadurch, dass er auch mindestens einen Messschaltkreis (DET_{A}, DET_{B}) eines Signals beinhaltet, das der Ausbreitung des Funkfrequenzsignals in der Komponente des integrierten Schaltkreises folgend erzeugt wurde, wobei der mindestens eine Messschaltkreis angepasst ist, um mindestens ein
Merkmal der Komponente abzuleiten, wobei der mindestens eine Verstärker (LNA, PA) einen Feldeffekttransistor (M_{Cc}, M_{osc}) beinhaltet, der als Schalter durch ein Funktionsmodus-Steuersignal (MODE_{LNA}) gesteuert wird, wobei der als Schalter gesteuerte Feldeffekttransistor eine Reaktionsschleife zwischen zwei Knoten des Verstärkers bildet, wobei die Schlaufe im Betriebsmodus, entsprechend einem blockierten Modus des Transistors, offen, und entsprechend einem Durchlassmodus des Transistors im Selbsttestmodus geschlossen ist.

2. Integrierter Schaltkreis nach Anspruch 1, wobei der mindestens eine Messschaltkreis ein Messschaltkreis (DET_{A}, DET_{B}) eines Niederfrequenzmerkmals des Funkfrequenzsignals ist.

3. Integrierter Schaltkreis nach Anspruch 2, wobei der mindestens eine Messschaltkreis (DET_{A}, DET_{B}) ein Messschaltkreis der Spitzenspannung ist.

4. Integrierter Schaltkreis nach einem der Ansprüche 1 bis 3, beinhaltend einen Empfangskanal mit mindestens einer ersten Verstärkerstufe (LNA1) und einen Übertragungskanal mit mindestens einer letzten Verstärkerstufe (PA2), wobei der mindestens eine Funkfrequenzsignalverstärker die erste Verstärkerstufe (LNA1) des Empfangskanals oder die letzte Verstärkerstufe (PA2) des Sendekanals ist, und durch seinen Eingang oder seinen Ausgang mit einer Antennenanschlusskontaktstelle (P2) gekoppelt ist.

5. Integrierter Schaltkreis nach einem der Ansprüche 1 bis 4, wobei der als Schalter gesteuerte Feldeffekttransistor die Reaktionsschleife zwischen einem mit dem Ausgang gekoppelten Knoten des Verstärkers und einem mit seinem Eingang gekoppelten Knoten bildet.

6. Integrierter Schaltkreis nach einem der Ansprüche 1 bis 5, wobei der mindestens eine Verstärker ein Differentialpaar ist und wobei die Reaktionsschleife den als Schalter gesteuerten Feldeffekttransistor beinhaltet, der zwischen einem nicht-invertierenden Eingang und einem invertierenden Ausgang des Differentialpaars angeschlossen ist, wobei der integrierte Schaltkreis eine zweite Reaktionsschleife beinhaltet, die einen zweiten durch das Funktionsmodus-Steuersignal als Schalter gesteuerten Feldeffekttransistor beinhaltet, und zwischen einem invertierenden Eingang und einem nicht-invertierenden Ausgang des Differentialpaars angeschlossen ist,
wobei jeder der zwei als Schalter gesteuerten Feldeffekttransistoren im Betriebsmodus eine Neutralisationskapazität (Cc) und im Selbsttestmodus des integrierten Schaltkreises einen Kurzschluss bildet, wobei der elektronische Oszillatorverstärker konfiguriert wird.

7. Integrierter Schaltkreis nach einem der Ansprüche 1 bis 4, wobei der mindestens eine Verstärker vom nicht-differentiellen Typ ist und Folgendes beinhaltet:
- einen ersten Feldeffekttransistor (M1), mit gemeinsamer Source montiert und von dem eine Gitterelektrode ein Signaleingang (IN_{LNA1}) des Verstärkers bildet, in Reihe mit einem zweiten Feldeffekttransistor (M2), von dem eine Drain-Elektrode (d) einen Ausgangsknoten des Signals (OUT_{LNA1}) des Verstärkers bildet,
- einen Resonanzschaltkreis (LC_{LNA1}) zur Lastabstimmung des Ausgangsknotens (OUT_{LNA1}), beinhaltend zwei Kondensatoren (C1ₗₙₐ, C2ₗₙₐ) in Reihe, und
- die durch das logische Steuersignal des Funktionsmodus gesteuerte Reaktionsschleife, wobei die Reaktionsschleife den als Schalter gesteuerten Feldeffekttransistor beinhaltet, der zwischen einem Anschlussknoten zwischen dem ersten und dem zweiten Feldeffekttransistor und einem Anschlussknoten zwischen den zwei Kondensatoren angeschlossen ist.

8. Integrierter Schaltkreis nach Anspruch 4, wobei die erste Verstärkerstufe (LNA1) des Empfangskanals und die letzte Verstärkerstufe (PA2) des Sendekanals (TX) im Betriebsmodus jeweils eine Verstärkungsfunktion und im Selbsttestmodus des integrierten Schaltkreises eine Oszillatorfunktion aufweisen, die durch ein jeweiliges Modus-Steuersignal (MODE_{PA}, MODE_{LNA}) gesteuert wird.

9. Integrierter Schaltkreis nach Anspruch 8, weiter umfassend Rückkopplungsmittel (X_{LP2}) eines Ausgangs (OUT_{PA}) des Sendekanals (TX) an einem Eingang (IN_{LNA}) des Empfangskanals (RX) und mindestens einen Messschaltkreis (DET_{B}) eines Niederfrequenzmerkmals des Ausgangssignals des Empfangskanals (RX).

10. Integrierter Schaltkreis nach Anspruch 9, weiter umfassend Rückkopplungsmittel (X_{LP1}) eines Ausgangs des Empfangskanals (RX) an einem Eingang des Empfangskanals (TX) und einen Messschaltkreis (DET_{A}, DET'_{A}) eines Niederfrequenzmerkmals des am Ausgang des Sendekanals gemessenen Signals.

11. Integrierter Schaltkreis nach einem der Ansprüche 1 bis 10, wobei der oder die Messschaltkreise des Niederfrequenzmerkmals einen Detektionsschaltkreis der Spitzenspannung beinhalten, die mit einem jeweiligen oder gemeinsamen Analog-DigitalWandler assoziiert sind.

12. Verfahren zum Selbsttest eines integrierten Funkfrequenz-Schaltkreises nach einem der Ansprüche 1 bis 11, beinhaltend die folgenden Schritte:
a) Konfigurieren des mindestens einen Verstärkers (LNA, PA) des Funkfrequenzsignals als Oszillator, um an mindestens einem des Eingangs oder des Ausgangs des mindestens einen Verstärkers ein Funkfrequenzsignal (Sin_{RF}) zu erzeugen;
b) Ausbreiten des Funkfrequenzsignals in mindestens eine Komponente des integrierten Funkfrequenzschaltkreises, der sich von dem mindestens einen Verstärker unterscheidet; und
c) Messen eines der Ausbreitung des Funkfrequenzsignals in der Komponenten des integrierten Schaltkreises folgend erzeugten Signals und Ableiten mindestens eines Merkmals der Komponente daraus.

13. Verfahren nach Anspruch 12, wobei der Schritt c) die Messung eines Niederfrequenzmerkmals des Funkfrequenzsignals beinhaltet.

14. Verfahren nach Anspruch 13, wobei der Schritt c) auch die Bestimmung einer Lastimpedanz des mindestens einen Verstärkers beinhaltet, wenn sein Eingang oder sein Ausgang mit einer Antenne oder einer äquivalenten Impedanzlast (Z_{ANT}) verbunden ist.

15. Verfahren nach einem der Ansprüche 12 bis 14, wobei der integrierte Schaltkreis einen Empfangskanal mit mindestens einer ersten Verstärkerstufe (LNA1) und einen Übertragungskanal mit mindestens einer letzten Verstärkerstufe (PA2) beinhaltet, wobei der mindestens eine Funkfrequenzsignalverstärker die erste Verstärkerstufe (LNA1) des Empfangskanals oder die letzte Verstärkerstufe (PA2) des Sendekanals ist, und durch seinen Eingang oder seinen Ausgang mit einer Antennenanschlusskontaktelle (P2) gekoppelt ist; wobei das Verfahren einen Testschritt der Antennenverbindung beinhaltet, der Folgendes beinhaltet:
- den Anschluss einer Antenne oder einer äquivalenten Impedanzlast (Z_{ANT}) an die Antennenanschlusskontaktstelle,
- die Aktivierung eines Steuersignals (MOSE_{LNA}) zum Steuern einer Neukonfiguration als elektronischen Oszillator einer Verstärkerstufe, die mit der Antennenkontaktstelle gekoppelt ist, die die erste Verstärkerstufe des Empfangskanals oder die letzte Verstärkerstufe des Sendekanals ist, und
- die Messung eines Niederfrequenzmerkmals eines zwischen der mindestens einen Verstärkerstufe und der Antennenanschlusskontaktstelle (P2) gemessenen Signals, das jeweils für eine Lastimpedanz der Antenne repräsentativ ist, wodurch erlaubt wird, zwischen einer guten und einer schlechten Antennenverbindung zu unterscheiden.

16. Verfahren nach Anspruch 15, wobei der integrierte Funkfrequenz-Schaltkreis weiter erste Rückkopplungsmittel (X_{LP2}) des Ausgangs der letzten Verstärkerstufe (PA2) des Sendekanals am Eingang der ersten Verstärkerstufe (LNA1) des Empfangskanals und mindestens einen Messschaltkreis (DET_{B}) eines BF-Merkmals des gemessenen Signals an einem Ausgang des Empfangskanals umfasst, wobei das Testverfahren weiter einen Verifikationsschritt des Empfangskanals (TEST-RX) umfasst, der die folgenden Schritte umfasst:
- Aktivierung eines Steuersignals (MOSE_{PA}) zum Steuern einer Neukonfiguration als elektronischen Oszillator der letzten Verstärkerstufe (PA2) des Sendekanals zum Erzeugen eines sinusförmigen HF-Kalibrierungssignals am Ausgang,
- Aktivierung der ersten Rückkopplungsmittel (X_{LP2}) zum Injizieren des HF-Kalibrierungssignals am Eingang der ersten Verstärkerstufe des Empfangskanals und
- Messung eines BF-Merkmals des HF-Kalibrierungssignals und eines entsprechenden Signals, das am Ausgang des Empfangskanals abgegeben wird, um einen Empfangskanalgewinn zu etablieren.

17. Verfahren nach Anspruch 16, umfassend einen zusätzlichen Schritt der spektralen Analyse des am Ausgang des Empfangskanals abgegebenen Signals zum Etablieren eines Rauschpegels des Empfangskanals.

18. Verfahren nach einem der Ansprüche 15 bis 17, wobei der integrierte Funkfrequenz-Schaltkreis weiter zweite Rückkopplungsmittel (X_{LP1}) eines Ausgangs des Empfangskanals an einem Eingang des Sendekanals beinhaltet, wobei das Selbsttestverfahren weiter einen Schritt der Verifikation des Sendekanals (TEST-TX) umfasst, der die folgenden Schritte umfasst:
- Aktivierung eines Steuersignals (MODE_{LNA}) zum Steuern einer Neukonfiguration als elektronischen Oszillator der letzten Verstärkerstufe (LNA1) des Sendekanals zum Erzeugen eines sinusförmigen HF-Signals in dem Empfangskanal und Erhalten eines HF-Kalibrierungssignals am Ausgang des Kanals,
- Aktivierung der zweiten Rückkopplungsmittel (X_{LP1}) zum Injizieren des HF-Kalibrierungssignals am Eingang des Sendekanals und
- Messung eines BF-Merkmals des HF-Kalibrierungssignals und eines entsprechenden Signals, das am Ausgang des Sendekanals abgegeben wird, um einen Sendekanalgewinn zu etablieren.

## Claims

1. Radiofrequency transmission and/or reception integrated circuit (FEM) comprising at least one radiofrequency signal amplifier (LNA, PA), said at least one amplifier being configured, in operational mode, so as to perform a function of amplifying a radiofrequency signal applied at an input, said amplifier being configured so as to perform an oscillator function in a self-test mode of the integrated circuit, to generate a radiofrequency signal (Sin_{RF}) on at least one of the input or the output of said amplifier, the integrated circuit being configured, in said self-test mode, so as to allow said radiofrequency signal to propagate in at least one component of said radiofrequency integrated circuit, separate from said amplifier, and in that it also comprises a measuring circuit (DET_{A}, DET_{B}) for measuring a signal generated following propagation of said radiofrequency signal in said component of said integrated circuit, said at least one measuring circuit being suitable for deducing at least one characteristic of said component, said at least one amplifier (LNA, PA) comprising a field-effect transistor (M_{Cc}, M_{osc}) controlled as a switch by the operational mode control signal (MODE_{LNA}), said field-effect transistor controlled as a switch forming a feedback loop between two nodes of the amplifier, said loop being open, corresponding to a blocked mode of said transistor, in operational mode, and closed, corresponding to a loop mode of said transistor, in self-test mode.

2. Integrated circuit according to claim 1, wherein said at least one measuring circuit is a measuring circuit (DET_{A}, DEB_{B}) for measuring a low-frequency characteristic of said radiofrequency signal.

3. Integrated circuit according to claim 2, wherein said at least one measuring circuit (DET_{A}, DET_{B}) is a peak voltage measuring circuit.

4. Integrated circuit according to any one of claims 1 to 3, comprising a reception path having at least one first amplifier stage (LNA1) and a transmission path having at least one last amplifier stage (PA2), wherein said at least one radiofrequency signal amplifier is the first amplifier stage (LNA1) of the reception path or the last amplifier stage (PA2) of the transmission path and is coupled, via its input or its output, to an antenna connection pad (P2).

5. Integrated circuit according to any one of claims 1 to 4, wherein said field-effect transistor controlled as a switch forms the feedback loop between a node coupled to the output of the amplifier and a node coupled to its input.

6. Integrated circuit according to any one of claims 1 to 5, wherein said at least one amplifier is a differential-pair amplifier and wherein the feedback loop comprises the field-effect transistor controlled as a switch connected between a non-inverting input and an inverting output of the differential pair, the integrated circuit comprising a second feedback loop comprising a second field-effect transistor controlled as a switch by the operational mode control signal and connected between an inverting input and a non-inverting output of the differential pair, wherein each one of the two field-effect transistors controlled as a switch forms a Neutrodyne capacitor (Cc) in operational mode and a short-circuit in self-test mode of the integrated circuit, then configuring said amplifier as an electronic oscillator.

7. Integrated circuit according to any one of claims 1 to 4, wherein said at least one amplifier is a non-differential amplifier and comprises:
- a first field-effect transistor (M1) in a common source configuration and a gate electrode of which forms a signal input (IN_{LNA1}) of the amplifier, in series with a second field-effect transistor (M2) of which a drain electrode (d) forms a signal output node (OUT_{LNA1}) of the amplifier,
- a resonant circuit (LC_{LNA1}) for tuning the load of the output node (OUT_{LNA1}), comprising two capacitors in series (C1ₗₙₐ, C2ₗₙₐ), and
- a feedback loop controlled by the logic operating mode control signal, the feedback loop comprising the field-effect transistor controlled as a switch connected between a connection node between said first and second field-effect transistors and a connection node between the two capacitors.

8. Integrated circuit according to claim 4 wherein said first amplifier stage (LNA1) of the reception path (RX) and said last amplifier stage (PA2) of the transmission path (TX) each have an amplification function in operational mode and an oscillator function in self-test mode of the integrated circuit, controlled by a respective mode control signal (MODE_{PA}, MODE_{LNA}).

9. Integrated circuit according to claim 8, furthermore comprising loopback means (X_{LP2}) for looping an output (OUT_{PA}) of the transmission path (TX) back to an input (IN_{LNA}) of the reception path (RX) and at least one measuring circuit (DET_{B}) for measuring a low-frequency characteristic of the signal at the output of the reception path (RX).

10. Integrated circuit according to claim 9, furthermore comprising loopback means (X_{LP1}) for looping an output of the reception path (RX) back to an input of the transmission path (TX) and a measuring circuit (DET_{A}, DET'_{A}) for measuring a low-frequency characteristic of the signal measured at the output of the transmission path.

11. Integrated circuit according to any one of claims 1 to 10, wherein the measuring circuit or circuits for measuring the low-frequency characteristic comprise a peak voltage detection circuit associated with a respective or shared analogue-to-digital converter.

12. Self-test method for a radiofrequency integrated circuit according to any one of claims 1 to 11, comprising the following steps:
a) configuring the at least one radiofrequency signal amplifier (LNA, PA) as an oscillator, in order to generate a radiofrequency signal (Sin_{RF}) on at least one of the input or the output of said at least one amplifier;
b) propagating said radiofrequency signal in at least one component of said radiofrequency integrated circuit, separate from said at least one amplifier; and
c) measuring a signal generated following propagation of said radiofrequency signal in said component of said integrated circuit, and deducing at least one characteristic of said component therefrom.

13. Method according to claim 12, wherein step c) comprises measuring a low-frequency characteristic of said radiofrequency signal.

14. Method according to claim 13, wherein step c) also comprises determining a load impedance of said at least one amplifier when its input or its output is connected to an antenna or to an equivalent impedance load (Z_{ANT}).

15. Method according to any one of claims 12 to 14, wherein the integrated circuit comprises a reception path having at least one first amplifier stage (LNA1) and a transmission path having at least one last amplifier stage (PA2), wherein said at least one radiofrequency signal amplifier is the first amplifier stage (LNA1) of the reception path or the last amplifier stage (PA2) of the transmission path and is coupled, via its input or its output, to an antenna connection pad (P2); the method comprising an antenna connection test step comprising:
- connecting an antenna or an equivalent impedance load (Z_{ANT}) to said antenna connection pad,
- activating a control signal (MOSE_{LNA}), in order to control reconfiguration of an amplifier stage coupled to said antenna pad, which is the first amplifier stage of the reception path or the last amplifier stage of the transmission path, as an electronic oscillator, and
- measuring a low-frequency characteristic of a signal measured between said at least one amplifier stage and said antenna connection pad (P2), representative of an antenna load impedance, in order to discriminate between a correct and an incorrect antenna connection.

16. Method according to claim 15, the radiofrequency integrated circuit furthermore comprising first loopback means (X_{LP2}) for looping back the output of said last amplifier stage (PA2) of the transmission path at the input of said first amplifier stage (LNA1) of the reception path, and a measuring circuit (DET_{B}) for measuring an LF characteristic of the measured signal on an output of the reception path, the test method furthermore comprising a step of checking the reception path (TEST-RX), comprising the following steps:
- activating a control signal (MOSE_{PA}) in order to control reconfiguration of said last amplifier stage (PA2) of the transmission path as an electronic oscillator, in order to generate a sinusoidal RF calibration signal at output,
- activating said first loopback means (X_{LP2}) in order to inject said RF calibration signal at input of said first amplifier stage of the reception path, and
- measuring an LF characteristic of said RF calibration signal and a corresponding signal delivered at output of the reception path, in order to establish a reception path gain.

17. Method according to claim 16, comprising an additional step of spectral analysis of the signal delivered at output of the reception path, in order to establish a noise level of the reception path.

18. Method according to any one of claims 15 to 17, the radiofrequency integrated circuit furthermore comprising second loopback means (X_{LP1}) for looping back an output of the reception path to an input of the transmission path, the self-test method furthermore comprising a step of checking the transmission path (TEST-TX), comprising the following steps:
- activating a control signal (MOSE_{LNA}) in order to control reconfiguration of said first amplifier stage (LNA1) of the transmission path as an electronic oscillator, in order to generate an RF sinusoidal signal in said reception path and obtain an RF calibration signal at the output of said path,
- activating said second loopback means (X_{LP1}) in order to inject said RF calibration signal at the input of the transmission path, and
- measuring an LF characteristic of said RF calibration signal and a corresponding signal delivered at the output of the transmission path, in order to establish a transmission path gain.
